# EUROPEAN PATENT APPLICATION

(11) **EP 4 498 432 A2**
(43) Date of publication of application: **29.01.2025**
(21) Application number: 24190138.8
(22) Date of filing: 22.07.2024
(51) Int. Cl.: H01L 25/075, H01L 25/16, H01L 33/62

(54) **DISPLAY DEVICE**

(30) Priority: 26.07.2023 KR 20230097585
(71) Applicant: Samsung Display Co., Ltd., Gyeonggi-do 17113 (KR)
(72) Inventor: PARK, Do Yeong, 17113 Yongin-si (KR); KIM, Kyung Bae, 17113 Yongin-si (KR); PYO, Ki Hyun, 17113 Yongin-si (KR); HONG, Sung Chul, 17113 Yongin-si (KR)
(74) Representative: Taor, Simon Edward William

(57) **Abstract**

A pixel circuit layer (PCL) of a display device is on a base layer (BSL) and includes conductive patterns configuring at least one of a transistor, a capacitor, or a signal line. A first electrode (ELT1) and a second electrode (ELT2) are on the pixel circuit layer (PCL) and are spaced from each other. A bank (not shown in figure 10) is on the first electrode (ELT1) and the second electrode (ELT2) and includes an opening. Light emitting elements (LD) are between the first electrode (ELT1) and the second electrode (ELT2) in the opening of the bank. In the opening of the bank, a space between the first electrode (ELT1) and the second electrode (ELT2) that are spaced from each other by a distance corresponding to a length of the light emitting elements (LD) is defined as a lane (EA) in which the light emitting elements (LD) are located. In a plan view, the lane (EA) does not overlap conductive patterns of the pixel circuit layer (PCL), and is spaced from said patterns by half of the length of the light emitting elements (LD).

## Description

### CROSS-REFERENCE TO RELATED APPLICATION

The present application claims priority to and the benefit of Korean Patent Application No. 10-2023-0097585, filed on July 26, 2023, in the Korean Intellectual Property Office.

### BACKGROUND

### 1. Field

The present disclosure relates to a display device.

### 2. Description of the Related Art

As interest in information display and demand for using a portable information medium increases, demand for and commercialization of a display device is in focus.

### SUMMARY

Aspects and features of embodiments of the present disclosure are to provide a display device including substantially uniformly aligned light emitting elements.

According to one or more embodiments of the present disclosure, a display device includes a pixel circuit layer on a base layer and including conductive patterns configuring at least one of a transistor, a capacitor, or a signal line, a first electrode and a second electrode on the pixel circuit layer and spaced from each other, a bank on the first electrode and the second electrode and including an opening, and light emitting elements between the first electrode and the second electrode in the opening of the bank. In the opening of the bank, a space between the first electrode and the second electrode that are spaced from each other by a distance corresponding to a length of the light emitting elements is defined as a lane in which the light emitting elements are located. In a plan view, the lane does not overlap the conductive patterns of the pixel circuit layer and is spaced from the conductive patterns by a distance equal to or greater than half of the length of the light emitting elements.

The length of the light emitting elements may be about 10 µm or less, and in a plan view, the lane may be spaced from the conductive patterns by a distance of about 6 µm or more.

The pixel circuit layer may further include insulating layers, some of the conductive patterns may be interconnected through a contact hole passing through a portion of the insulating layers, and in a plan view, the lane may be spaced from all contact holes by a distance equal to or greater than half of the length of the light emitting elements.

The display device may further include sub-pixels each including the lane, the conductive patterns may include a first line extending in a second direction, and from among the sub-pixels, a first sub-pixel and a second sub-pixel adjacent in a first direction with the first line interposed therebetween are symmetric with each other with respect to the first line in a plan view.

The first sub-pixel and the second sub-pixel may share the first line.

The first line may be repeatedly arranged along the first direction with a distance corresponding to two of the sub-pixels.

The conductive patterns may include a first power line and a second power line extending in the second direction, the light emitting elements may be electrically connected between the first power line and the second power line, the first power line and the second power line may be spaced from each other with a gap corresponding to two of the sub-pixels, and each of the first power line and the second power line may be repeatedly arranged along the first direction with a distance corresponding to four of the sub-pixels.

Each of the first power line and the second power line may include three conductive layers that are spaced with insulating layers interposed therebetween.

The conductive patterns may further include a first auxiliary power line and a second auxiliary power line extending in the first direction, the first auxiliary power line may be electrically connected to the first power line, and the second auxiliary power line may be electrically connected to the second power line.

The first electrode and the second electrode may extend in the second direction and may be alternately and repeatedly arranged along the first direction, and the first electrode may be electrically connected to the first power line through a first connection line extending in the first direction and a first contact hole.

The conductive patterns may include a first auxiliary power line extending in a first direction, and a first capacitor and a second capacitor spaced in a second direction with the first auxiliary power line interposed therebetween in a plan view, and the first capacitor and the second capacitor may be electrically connected in parallel.

The display device may further include connection electrodes on the light emitting elements, the lane may include a first lane, a second lane, a third lane, and a fourth lane that are spaced from each other in the opening of the bank, the light emitting elements may include first light emitting elements in the first lane, second light emitting elements in the second lane, third light emitting elements in the third lane, and fourth light emitting elements in the fourth lane, and the first to fourth light emitting elements may be electrically connected in series through the connection electrodes.

A portion of the connection electrodes may include a closed loop.

The display device may further include color conversion particles on the light emitting elements and converting a wavelength of light of the light emitting elements, and a color filter on the color conversion particles.

The conductive patterns may include a first auxiliary power line extending in a first direction, and in a plan view, the lane of a sub-pixel may be in an area that is different from the transistor and the capacitor of the pixel circuit layer of the sub-pixel based on the first auxiliary power line.

The display device may further include a first sub-pixel and a second sub-pixel, each of the first sub-pixel and the second sub-pixel including the lane, the conductive patterns may include first lines extending in a second direction, and the first sub-pixel and the second sub-pixel that are adjacent with two of the first lines interposed therebetween are symmetric with each other with respect to the two of the first lines in a plan view.

Three of the first lines may be connected to one pad.

The display device may further include sub-pixels, each of the sub-pixels including the lane, the conductive patterns may include first lines extending in a second direction, from among the sub-pixels, a first sub-pixel and a second sub-pixel adjacent with one of the first lines interposed therebetween are symmetric with each other with respect to the one of the first line in a plan view, and at least two of the first lines may be connected to one pad.

According to one or more embodiments of the present disclosure, a display device includes sub-pixels arranged along a first direction, and a signal line extending in a second direction between a pair of adjacent sub-pixels from among the sub-pixels. Each of the sub-pixels includes a pixel circuit including a transistor and a capacitor, a first electrode and a second electrode electrically connected to the pixel circuit and spaced from each other in a plan view, and light emitting elements in a lane between the first electrode and the second electrode. A conductive pattern is not in the lane. The pair of adjacent sub-pixels are commonly connected to the signal line and are symmetric with each other with respect to the signal line.

In a plan view, the lane may be located in an area that is different from the transistor based on the first line extending in a first direction, the pixel circuit may include a first capacitor and a second capacitor that are spaced in the second direction with the first line interposed therebetween, and the first capacitor and the second capacitor may be electrically connected in parallel.

In the display device according to one or more embodiments, the conductive patterns (for example, the transistor, the capacitor, and the contact hole) of the pixel circuit layer may be spaced from the lane in which the light emitting elements are located by a predetermined distance. Therefore, an influence of the conductive patterns on electrical signals (for example, an electric field, or the like) for aligning the light emitting elements may be reduced, and an alignment degree of the light emitting elements may be improved. That is, the display device may include more uniformly aligned light emitting elements.

According to an aspect, there is provided a display device as set out in claim 1. Additional features are set out in claims 2 to 13. According to an aspect, there is provided a display device as set out in claim 14. Additional features are set out in claim 15.

Effects, aspects, and features of the present disclosure are not limited by the content exemplified above, and more various effects, aspects, and features are included in the present disclosure.

### BRIEF DESCRIPTION OF THE DRAWINGS

The above and other features of the present disclosure will become more apparent by describing in further detail embodiments thereof with reference to the accompanying drawings, in which:
FIG. 1 is a perspective cutaway view illustrating a light emitting element according to one or more embodiments;
FIG. 2 is a cross-sectional view illustrating a light emitting element according to one or more embodiments;
FIG. 3 is a plan view illustrating a display device according to one or more embodiments;
FIG. 4 is a circuit diagram illustrating an embodiment of a sub-pixel included in the display device of FIG. 3;
FIG. 5 is a cross-sectional view illustrating an embodiment of the display device of FIG. 3;
FIG. 6 is a plan view illustrating an embodiment of the sub-pixel included in the display device of FIG. 3;
FIG. 7 is a cross-sectional view illustrating an embodiment of the sub-pixel taken along the line I-I' of FIG. 6;
FIG. 8 is a cross-sectional view illustrating an embodiment of the sub-pixel taken along the line I-I' of FIG. 6;
FIG. 9 is a cross-sectional view illustrating an embodiment of the pixel included in the display device of FIG. 3;
FIG. 10 is a schematic cross-sectional view illustrating a disposition relationship between an alignment electrode layer and lower lines according to one or more embodiments;
FIG. 11 is a plan view illustrating an embodiment of the display device of FIG. 3;
FIG. 12 is a layout diagram illustrating an embodiment of first and second sub-pixels included in the display device of FIG. 11;
FIG. 13 is a cross-sectional view illustrating an embodiment of a storage capacitor taken along the line II-II' of FIG. 12;
FIGS. 14, 15, and 16 are layout diagrams illustrating an embodiment of the first and second sub-pixels included in the display device of FIG. 11;
FIG. 17 is a layout diagram illustrating an embodiment of the first and second sub-pixels included in the display device of FIG. 11;
FIG. 18 is a layout diagram illustrating an embodiment of the first and second sub-pixels included in the display device of FIG. 3;
FIG. 19 is a layout diagram illustrating an embodiment of the first and second sub-pixels included in the display device of FIG. 3; and
FIGS. 20, 21, and 22 are plan views illustrating an embodiment of the display device of FIG. 3.

### DETAILED DESCRIPTION

The present disclosure may be modified in various manners and have various forms. Therefore, specific embodiments will be illustrated in the drawings and will be described in detail in the specification. However, it should be understood that the present disclosure is not intended to be limited only to embodiments discussed in the present disclosure, and the present disclosure includes all modifications, equivalents, and substitutions within the technical scope of the present disclosure.

Terms of "first", "second", and the like may be used to describe various components, but the components should not be limited by the terms. The terms are used only for the purpose of distinguishing one component from another component. For example, without departing from the scope of the present disclosure, a first component may be referred to as a second component, and similarly, a second component may also be referred to as a first component. In the following description, the singular expressions include plural expressions unless the context clearly dictates otherwise.

It should be understood that in the present application, a term of "include", "have", or the like is used to specify that there is a feature, a number, a step, an operation, a component, a part, or a combination thereof described in the specification, but does not exclude a possibility of the presence or addition of one or more other features, numbers, steps, operations, components, parts, or combinations thereof in advance. In addition, a case where a portion of a layer, an area, a plate, or the like is referred to as being "on" another portion includes not only a case where the portion is "directly on" another portion, but also a case where there is further another portion between the portion and another portion. In addition, in the present specification, when a portion of a layer, an area, a plate, or the like is formed on another portion, a forming direction is not limited to an upper direction but includes forming the portion on a side surface or in a lower direction. On the contrary, when a portion of a layer, an area, a plate, or the like is formed "under" another portion, this includes not only a case where the portion is "directly beneath" another portion but also a case where there is further another portion between the portion and another portion.

In the following description, a case where a portion is connected to another portion includes a case where they are electrically connected to each other with another element interposed therebetween as well as a case in which they are directly connected to each other. In an embodiment of the present disclosure, a term "connection" between two configurations may mean that both of an electrical connection and a physical connection are inclusively used.

Hereinafter, a display device according to one or more embodiments is described with reference to drawings.

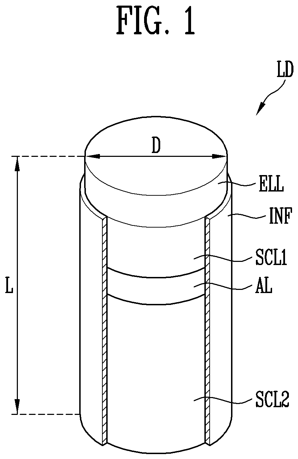

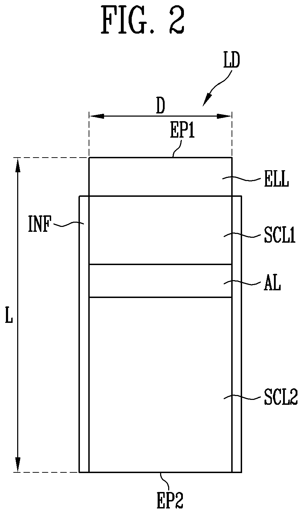

FIG. 1 is a perspective cutaway view illustrating a light emitting element according to one or more embodiments. FIG. 2 is a cross-sectional view illustrating a light emitting element according to one or more embodiments.

Referring to FIGS. 1 and 2, the light emitting element LD is configured to emit light. The light emitting element LD may include a first semiconductor layer SCL1, a second semiconductor layer SCL2, and an active layer AL disposed between the first semiconductor layer SCL1 and the second semiconductor layer SCL2. According to one or more embodiments, the first semiconductor layer SCL1, the active layer AL, and the second semiconductor layer SCL2 may be sequentially stacked along a length L direction of the light emitting element LD. According to one or more embodiments, the light emitting element LD may further include an electrode layer ELL and an insulating film INF.

The light emitting element LD may have various shapes. For example, the light emitting element LD may have a column shape extending in one direction. The column shape may include a rod-like shape or a bar-like shape that extends in the length L direction (for example, an aspect ratio is greater than 1), such as a circular column or a polygonal column, and a cross-sectional shape thereof is not particularly limited.

The light emitting element LD may have a first end EP1 and a second end EP2. According to one or more embodiments, the first semiconductor layer SCL1 may be adjacent to the first end EP1 of the light emitting element LD, and the second semiconductor layer SCL2 may be adjacent to the second end EP2. According to one or more embodiments, an electrode layer ELL may be adjacent to the first end EP1.

The light emitting element LD may be manufactured by etching sequentially stacked semiconductor layers. The light emitting element LD may have a size of a nano scale to a micro scale. For example, each of a diameter D (or a width) of the light emitting element LD and a length L of the light emitting element LD may be in a nano meter scale to a micro meter scale. For example, the diameter D of the light emitting element LD may be in a range of about 0.2 µm to about 5 µm, and the length L of the light emitting element LD may be in a range of about 1 µm to about 10 µm. For example, the diameter D of the light emitting element LD may be in a range of about 0.5 µm to about 0.6 µm, and the length L of the light emitting element LD may be in a range of about 3.5 µm to about 4 µm. However, the light emitting element LD of embodiments is not limited thereto.

The first semiconductor layer SCL1 may include a first conductivity type semiconductor. The first semiconductor layer SCL1 may be disposed on the active layer AL at one side of the active layer AL, and may include a semiconductor layer of a type different from that of the second semiconductor layer SCL2. For example, the first semiconductor layer SCL1 may include a p-type semiconductor layer. For example, the first semiconductor layer SCL1 may include one or more semiconductor materials selected from a group of InAlGaN, GaN, AlGaN, InGaN, AIN, and InN, and may include a p-type semiconductor layer doped with a first conductivity type dopant such as Ga, B, and/or Mg. However, embodiments of the present disclosure are not limited to the above-described example. The first semiconductor layer SCL1 may include various materials.

The active layer AL may be disposed between the first semiconductor layer SCL1 and the second semiconductor layer SCL2. The active layer AL may include a single-quantum well or multi-quantum well structure. A position of the active layer AL is not limited to a specific example and may be variously changed according to a type of the light emitting element LD.

A clad layer doped with a conductive dopant may be formed on one side and/or another side of the active layer AL. For example, the clad layer may include one or more of AlGaN and InAlGaN. However, the present disclosure are not necessarily limited to the above-described example.

The second semiconductor layer SCL2 may include a second conductivity type semiconductor. The second semiconductor layer SCL2 may be disposed on the active layer AL at another side of the active layer AL, and may include a semiconductor layer of a type different from that of the first semiconductor layer SCL1. For example, the second semiconductor layer SCL2 may include an n-type semiconductor layer. For example, the second semiconductor layer SCL2 may include one or more selected from a group of InAlGaN, GaN, AlGaN, InGaN, AIN, and InN, and may include an n-type semiconductor layer doped with a second conductivity type dopant such as Si, Ge, and/or Sn. However, the present disclosure are not limited to the above-described example. The second semiconductor layer SCL2 may include various materials.

When a voltage equal to or greater than a threshold voltage is applied to the first end EP1 and the second end EP2 of the light emitting element LD, an electron-hole pair may recombine with each other in the active layer AL, and the light emitting element LD may emit light. By controlling light emission of the light emitting element LD using such a principle, the light emitting element LD may be used as a light source in various devices.

The insulating film INF may be disposed on one surface of the light emitting element LD. The insulating film INF may be around (e.g., may surround) an outer surface (e.g., an outer peripheral or circumferential surface) of the active layer AL, and may further be around (e.g., may further surround) a portion of each of the first semiconductor layer SCL1 and the second semiconductor layer SCL2. The insulating film INF may have a single layer or multiple layer structure.

The insulating film INF may expose the first end EP1 and the second end EP2 of the light emitting element LD having different polarities. For example, the insulating film INF may expose one end of each of the electrode layer ELL and the second semiconductor layer SCL2 adjacent to the first end EP1 and the second end EP2 of the light emitting element LD. The insulating film INF may ensure electrical stability of the light emitting element LD. In addition, the insulating film INF may reduce or minimize a surface defect of the light emitting element LD to improve lifespan and efficiency. In addition, when a plurality of light emitting elements LD are disposed in close to each other, the insulating film INF may prevent a short circuit between the light emitting elements LD.

According to one or more embodiments, the insulating film INF may include an inorganic material. For example, the inorganic material may include at least one of a group of silicon oxide (SiOₓ), silicon nitride (SiNₓ), silicon oxynitride (SiOₓN_{y}), aluminum oxide (AlOₓ), and titanium oxide (TiOₓ). However, the inorganic material of embodiments is not limited thereto.

The electrode layer ELL may be disposed on the first semiconductor layer SCL1. The electrode layer ELL may be adjacent to the first end EP1. The electrode layer ELL may be electrically connected to the first semiconductor layer SCL1. A portion of the electrode layer ELL may be exposed. For example, the insulating film INF may expose one surface of the electrode layer ELL. The electrode layer ELL may be exposed in an area corresponding to the first end EP1. According to one or more embodiments, a side surface of the electrode layer ELL may be exposed. For example, the insulating film INF may cover side surfaces of each of the first semiconductor layer SCL1, the active layer AL, and the second semiconductor layer SCL2, and may not cover at least a portion of the side surface of the electrode layer ELL. In this case, electrical connection to another configuration of the electrode layer ELL adjacent to the first end EP1 may be easy. According to one or more embodiments, the insulating film INF may expose a portion of the side surface of the first semiconductor layer SCL1 and/or the second semiconductor layer SCL2 as well as the side surface of the electrode layer ELL.

According to one or more embodiments, the electrode layer ELL may be an Ohmic contact electrode. However, the electrode layer ELL of embodiments is not limited thereto. For example, the electrode layer ELL may be a Schottky contact electrode.

According to one or more embodiments, the electrode layer ELL may include one or more of a group of chromium (Cr), titanium (Ti), aluminum (Al), gold (Au), nickel (Ni), an oxide thereof, and an alloy thereof. However, embodiments of the present disclosure are not necessarily limited to the above-described example. According to one or more embodiments, the electrode layer ELL may be substantially transparent. For example, the electrode layer ELL may include indium tin oxide (ITO). Accordingly, the electrode layer ELL may transmit emitted light.

A structure, a shape, or the like of the light emitting element LD is not limited to the above-described embodiment, and the light emitting element LD may have various structures and shapes according to one or more embodiments. For example, the light emitting element LD may further include an additional electrode layer disposed on one surface of the second semiconductor layer SCL2 and adjacent to the second end EP2. For example, the light emitting element LD may be formed in a core-shell structure having a polygonal cone shape.

A light emitting device including the light emitting element LD described above may be used in various types of devices requiring a light source, including a display device. For example, a plurality of light emitting elements LD may be disposed in each pixel of a display panel and the light emitting elements LD may be used as a light source of each pixel. However, an application field of the light emitting element LD is not limited to the above-described example. For example, the light emitting element LD may be used in other types of devices requiring a light source, such as a lighting device.

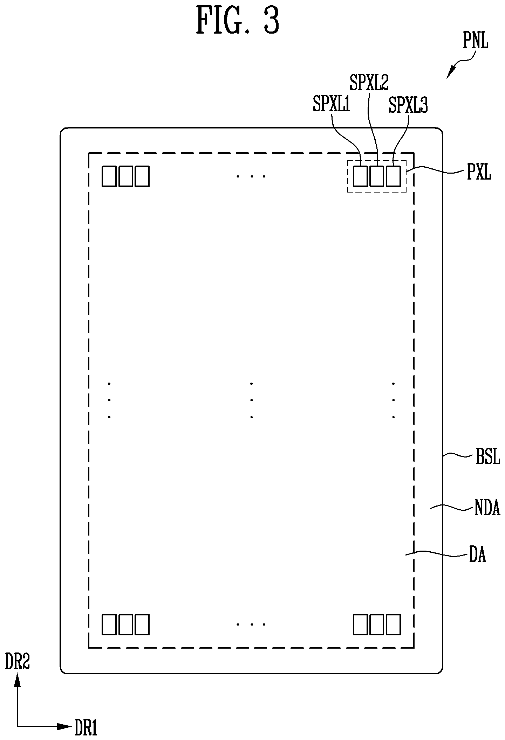

FIG. 3 is a plan view illustrating a display device according to one or more embodiments. FIG. 3 shows a display device, in particular, a display panel PNL included in the display device as an example of an electronic device capable of using the light emitting element LD described in the embodiments of FIGS. 1 and 2 as a light source.

For convenience of description, in FIG. 3, a structure of the display panel PNL is briefly shown based on a display area DA. According to one or more embodiments, at least one driving circuit unit (for example, at least one of a scan driver and a data driver), lines, and/or pads may be further disposed on the display panel PNL.

When a display device is an electronic device in which a display surface is applied to at least one surface, such as a smartphone, a television, a tablet PC, a mobile phone, a video phone, an e-book reader, a desktop PC, a laptop PC, a notebook computer, a workstation, a server, a PDA, a portable multimedia player (PMP), an MP3 player, a medical device, a camera, and/or a wearable device, the present disclosure may be applied.

Referring to FIG. 3, the display panel PNL may include a base layer BSL and pixels PXL disposed on the base layer BSL.

The base layer BSL (or a substrate) may configure a base member of the display panel PNL, and may be a rigid or flexible substrate or film. For example, the base layer BSL may be a rigid substrate formed of glass or tempered glass, a flexible substrate (or thin film) of a plastic or metal material, and/or at least one insulating layer. A material and/or a physical property of the base layer BSL are/is not particularly limited.

In one or more embodiments, the base layer BSL may be substantially transparent. Here, "substantially transparent" may mean that light may be transmitted with a suitable transmittance (e.g., a predetermined transmittance) or higher. In one or more embodiments, the base layer BSL may be translucent or opaque. In addition, the base layer BSL may include a reflective material according to one or more embodiments.

The display panel PNL and the base layer BSL for forming the same may include the display area DA for displaying an image and a non-display area NDA excluding the display area DA. The non-display area NDA may be disposed around the display area DA along an edge or periphery of the display area DA.

A pixel PXL may be disposed in the display area DA. In the non-display area NDA, various lines, pads, and/or embedded circuit units connected to the pixel PXL in the display area DA may be disposed.

The pixel PXL may include sub-pixels SPXL1 to SPXL3. For example, the pixel PXL may include a first sub-pixel SPXL1, a second sub-pixel SPXL2, and a third sub-pixel SPXL3.

Each of the sub-pixels SPXL1 to SPXL3 may emit light of a desired color (e.g., a predetermined color). According to one or more embodiments, the sub-pixels SPXL1 to SPXL3 may emit light of different colors. For example, the first sub-pixel SPXL1 may emit light of a first color, the second sub-pixel SPXL2 may emit light of a second color, and the third sub-pixel SPXL3 may emit light of a third color. For example, the first sub-pixel SPXL1 may be a red pixel emitting red light, the second sub-pixel SPXL2 may be a green pixel emitting green light, and the third sub-pixel SPXL3 may be a blue pixel emitting blue light, but embodiments of the present disclosure are not limited thereto.

In one or more embodiments, the first sub-pixel SPXL1, the second sub-pixel SPXL2, and the third sub-pixel SPXL3 may include a light emitting element of a first color, a light emitting element of a second color, and a light emitting element of a third color as light sources to emit light of the first color, the second color, and the third color, respectively. In one or more embodiments, the first sub-pixel SPXL1, the second sub-pixel SPXL2, and the third sub-pixel SPXL3 may include light emitting elements emitting light of the same color, and may include color conversion layers and/or color filters of different colors disposed on each light emitting element to emit light of the first color, the second color, and the third color, respectively. However, a color, a type, the number, and/or the like of the sub-pixels SPXL1 to SPXL3 configuring each pixel PXL are/is not particularly limited. That is, a color of light emitted from each pixel PXL may be variously changed.

The sub-pixels SPXL1 to SPXL3 may be regularly arranged according to a stripe or PENTILE^{®} arrangement structure, or the like. The PENTILE^{®} pixel arrangement structure may be referred to as an RGBG matrix structure (e.g., a PENTILE^{®} matrix structure) or an RGBG structure (e.g., a PENTILE^{®} structure). PENTILE^{®} is a registered trademark of Samsung Display Co., Ltd., Republic of Korea. For example, the first, second, and third sub-pixels SPXL1, SPXL2, and SPXL3 may be sequentially and repeatedly disposed along a first direction DR1 and may be repeatedly disposed along a second direction DR2 crossing the first direction DR1. At least one of the first, second, and third sub-pixels SPXL1, SPXL2, and SPXL3 disposed adjacent to each other may configure one pixel PXL capable of emitting light of various colors. However, an arrangement structure of the sub-pixels SPXL1 to SPXL3 is not limited thereto, and the sub-pixels SPXL1 to SPXL3 may be arranged in the display area DA in various structures and/or methods.

In one or more embodiments, each of the sub-pixels SPXL1 to SPXL3 may be configured as an active pixel. For example, each of the sub-pixels SPXL1 to SPXL3 may include at least one light source (for example, a light emitting element LD) driven by a suitable control signal (e.g., a predetermined control signal, for example, a scan signal and a data signal) and/or a suitable power voltage (e.g., a predetermined power voltage, for example, a first power voltage and a second power voltage). However, a type, a structure, and/or a driving method of the sub-pixels SPXL1 to SPXL3 applicable to the display device are/is not particularly limited.

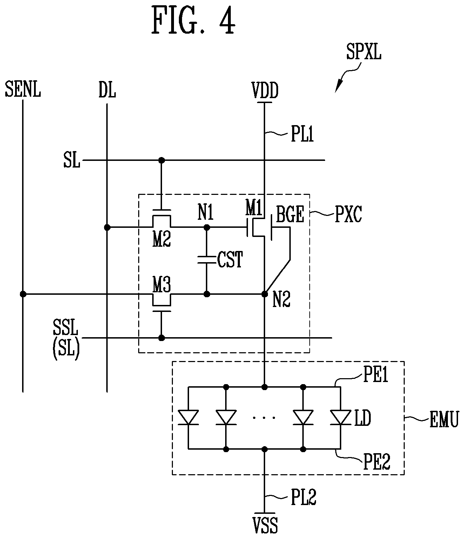

FIG. 4 is a circuit diagram illustrating an embodiment of a sub-pixel included in the display device of FIG. 3. The sub-pixels SPXL1 to SPXL3 of FIG. 3 are collectively referred to as the sub-pixel SPXL.

Referring to FIG. 4, the sub-pixel SPXL may include a light emitting unit EMU (or a light emitting unit) that generates light of a luminance corresponding to a data signal. In addition, the sub-pixel SPXL may selectively further include a pixel circuit PXC for driving the light emitting unit EMU.

According to one or more embodiments, the light emitting unit EMU may include a plurality of light emitting elements LD connected in parallel between a first power line PL1 and a second power line PL2. A voltage of first driving power VDD may be applied to the first power line PL1, and a voltage of second driving power VSS may be applied to the second power line PL2.

For example, the light emitting unit EMU may include a first pixel electrode PE1 (or a first electrode) connected to the first driving power VDD through the pixel circuit PXC and the first power line PL1, a second pixel electrode PE2 (a second electrode) connected to the second driving power VSS through the second power line PL2, and the plurality of light emitting elements LD connected in parallel in the same direction between the first pixel electrode PE1 and the second pixel electrode PE2. For example, the first pixel electrode PE1 may be an anode electrode of the light emitting unit EMU, and the second pixel electrode PE2 may be a cathode electrode of the light emitting unit EMU, but embodiments of the present disclosure are not limited thereto.

Each of the light emitting elements LD included in the light emitting unit EMU may include a first end connected to the first driving power VDD through the first pixel electrode PE1 and a second end connected to the second driving power VSS through the second pixel electrode PE2. The first driving power VDD and the second driving power VSS may have different potentials. For example, the first driving power VDD may be set as high potential power, and the second driving power VSS may be set as low potential power. At this time, a potential difference between the first driving power VDD and the second driving power VSS may be set as a threshold voltage or more of the light emitting element LD during a light emission period of each sub-pixel SPXL. Each of the first driving power VDD and the second driving power VSS may have a constant voltage, but embodiments are not limited thereto.

As described above, the respective light emitting elements LD connected in parallel in the same direction (for example, a forward direction) between the first pixel electrode PE1 and the second pixel electrode PE2 to which the voltages of the different power are supplied may configure respective effective light sources.

The light emitting elements LD of the light emitting unit EMU may emit light with a luminance corresponding to a driving current supplied through a corresponding pixel circuit PXC. For example, the pixel circuit PXC may supply a driving current corresponding to a grayscale value of corresponding frame data of the pixel circuit PXC to the light emitting unit EMU during each frame period. The driving current supplied to the light emitting unit EMU may be divided and may flow to each of the light emitting elements LD. Therefore, each of the light emitting elements LD may emit light with a luminance corresponding to the current flowing through the light emitting element LD, and thus the light emitting unit EMU may emit light of the luminance corresponding to the driving current.

In the above-described embodiment, an embodiment in which the both ends of the light emitting elements LD are connected in the same direction between the first and second driving power VDD and VSS is described, but embodiments of the present disclosure are not limited thereto. According to one or more embodiments, the light emitting unit EMU may further include at least one ineffective light source, for example, a reverse light emitting element, in addition to the light emitting elements LD configuring each effective light source. The reverse light emitting element may be connected in parallel between the first and second pixel electrodes PE1 and PE2 together with the light emitting elements LD configuring the effective light sources, and may be connected between the first and second pixel electrodes PE1 and PE2 in a direction opposite to the light emitting elements LD. The reverse light emitting element maintains an inactivation state even though a suitable driving voltage (e.g., a predetermined driving voltage, for example, a driving voltage of a forward direction) is applied between first and second pixel electrodes PE1 and PE2, and thus a substantial current does not flow through the reverse light emitting element.

According to one or more embodiments, the light emitting unit EMU may be configured in a series/parallel hybrid structure. For example, when the light emitting elements LD connected in parallel between the first pixel electrode PE1 and the second pixel electrode PE2 shown in FIG. 4 are defined as one series stage, the light emitting unit EMU may include a plurality of series stages connected in series between a second node N2 and the second power line PL2. For example, the light emitting unit EMU may include two, three, four or more series stages. The number of series stages included in the light emitting unit EMU may be variously changed. The light emitting unit EMU including series stages connected in series/parallel structure may easily adjust a driving current/voltage condition according to an applied product specification. As the number of series stages increases, the driving current may be decreased. In other words, as the number of series stages increases, the light emitting unit EMU may emit light with a higher luminance with respect to the same driving current. In addition, as the number of series stages decreases, the driving voltage applied to both ends of the light emitting unit EMU may be decreased.

The pixel circuit PXC may be connected to a scan line SL (or a first gate line) and a data line DL of the sub-pixel SPXL. In addition, the pixel circuit PXC may be connected to a sensing scan line SSL (or a second gate line) and a sensing line SENL (or a readout line) of the sub-pixel SPXL. According to one or more embodiments, the sensing scan line SSL may be connected to the scan line SL or may be the scan line SL.

The pixel circuit PXC may include transistors M1 to M3 and a storage capacitor CST (or a capacitor).

The first transistor M1 may be a driving transistor for controlling the driving current applied to the light emitting unit EMU, and may be connected between the first driving power VDD and the light emitting unit EMU. Specifically, a first terminal (or a first transistor electrode) of the first transistor M1 may be electrically connected to the first driving power VDD through the first power line PL1, a second terminal (or a second transistor electrode) of the first transistor M1 may be electrically connected to a second node N2, and a gate electrode of the first transistor M1 may be electrically connected to a first node N1. The first transistor M1 may control an amount of the driving current applied from the first driving power VDD to the light emitting unit EMU through the second node N2, according to a voltage applied to the first node N1. In one or more embodiments, the first terminal of the first transistor M1 may be a drain electrode, and the second terminal of the first transistor M1 may be a source electrode, but embodiments of the present disclosure are not limited thereto. According to one or more embodiments, the first terminal may be a source electrode and the second terminal may be a drain electrode.

According to one or more embodiments, a lower electrode BGE may be disposed under the first transistor M1. In this case, back-biasing technology moving a threshold voltage of the first transistor M1 in a negative direction or a positive direction by applying a back-biasing voltage to the lower electrode BGE when driving the sub-pixel SPXL may be applied.

The second transistor M2 may be a switching transistor that selects the sub-pixel SPXL in response to the scan signal and activates the sub-pixel SPXL, and may be connected between the data line DL and the first node N1. A first terminal of the second transistor M2 may be connected to the data line DL, a second terminal of the second transistor M2 may be connected to the first node N1, and a gate electrode of the second transistor M2 may be connected to the scan line SL. The first terminal and the second terminal of the second transistor M2 may be different terminals. For example, when the first terminal is a source electrode, the second terminal may be a drain electrode.

The second transistor M2 may be turned on when a scan signal of a gate-on voltage (for example, a high level voltage) is supplied from the scan line SL, to electrically connect the data line DL and the first node N1. The first node N1 may be a point where the second terminal of the second transistor M2 and the gate electrode of the first transistor M1 are connected, and the second transistor M2 may transmit the data signal to the gate electrode of the first transistor M1.

A first terminal of the third transistor M3 may be connected to the sensing line SENL, a second terminal of the third transistor M3 may be connected to the second terminal of the first transistor M1, and a gate electrode of the third transistor M3 may be connected to the sensing scan line SSL. Initialization power may be applied to the sensing line SENL. The third transistor M3 may be an initialization transistor capable of initializing the second node N2, and may be turned on when a sensing control signal is supplied from the sensing scan line SSL to transmit a voltage of the initialization power to the second node N2. Accordingly, a second storage electrode of the storage capacitor CST electrically connected to the second node N2 may be initialized. According to one or more embodiments, as the third transistor M3 may connect the first transistor M1 to the sensing line SENL, a sensing signal may be output through the sensing line SENL, and a characteristic of the sub-pixel SPXL including a threshold voltage or the like of the first transistor M1 may be detected using the sensing signal. Information on the characteristic of the sub-pixel SPXL may be used to convert image data so that a characteristic deviation between the sub-pixels SPXL may be compensated.

The storage capacitor CST may be electrically connected between the first node N1 and the second node N2 or may be formed between the first node N1 and the second node N2. The storage capacitor CST charges a data voltage corresponding to a data signal supplied to the first node N1 during one frame period. Accordingly, the storage capacitor CST may store a voltage corresponding to a difference between a voltage of the gate electrode of the first transistor M1 and a voltage of the second node N2.

In FIG. 4, all transistors M1 to M3 included in the pixel circuit PXC are n-type transistors, but embodiments are not limited thereto. For example, at least one of the transistors M1 to M3 may be changed to a p-type transistor.

In addition, a structure and a driving method of the sub-pixel SPXL may be variously changed. For example, the pixel circuit PXC may not include the third transistor M3. As another example, the pixel circuit PXC may further include other circuit elements such as a compensation transistor for compensating for the threshold voltage or the like of the first transistor M1, an initialization transistor for initializing a voltage of the first node N1 and/or the first pixel electrode PE1, an emission control transistor for controlling a period in which the driving current is supplied to the light emitting unit EMU, a boosting capacitor for boosting the voltage of the first node N1, and/or the like.

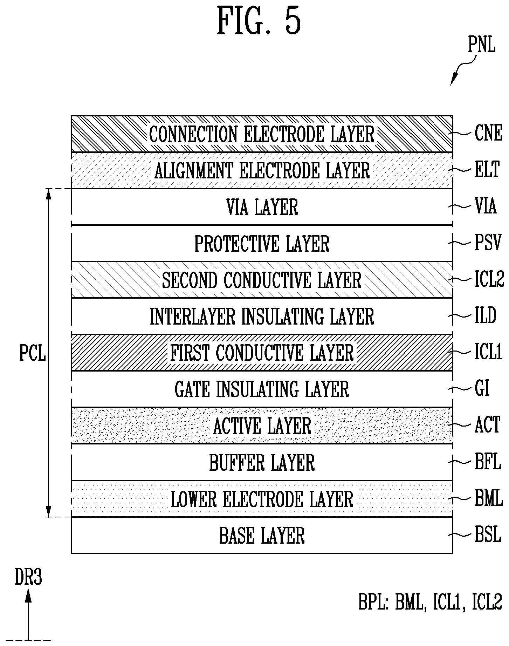

FIG. 5 is a cross-sectional view illustrating an embodiment of the display device of FIG. 3. FIG. 5 schematically shows a stack structure of the display panel PNL included in the display device.

Referring to FIG. 5, the display panel PNL may include a lower electrode layer BML (or an auxiliary electrode layer), a buffer layer BFL, an active layer ACT (or a semiconductor layer), a gate insulating layer GI, a first conductive layer ICL1, an interlayer insulating layer ILD, a second conductive layer ICL2, a protective layer PSV, a via layer VIA, an alignment electrode layer ELT (or a first electrode layer), and a connection electrode layer CNE (or a second electrode layer) sequentially stacked on the base layer BSL.

According to one or more embodiments, the lower electrode layer BML, the buffer layer BFL, the active layer ACT, the gate insulating layer GI, the first conductive layer ICL1, the interlayer insulating layer ILD, the second conductive layer ICL2, the protective layer PSV, and the via layer VIA may form a pixel circuit layer PCL including the pixel circuit PXC. According to one or more embodiments, the lower electrode layer BML, the first conductive layer ICL1, and the second conductive layer ICL2 may form lower lines BPL (a transistor, and a capacitor). Here, the lower lines BPL may be lines (for example, wires and electrodes) forming the pixel circuit layer PCL, and may include conductive patterns (or a component including a conductive material) formed under the alignment electrode layer ELT.

The buffer layer BFL may prevent diffusion of an impurity or moisture permeation into the active layer ACT. According to one or more embodiments, the buffer layer BFL may include an inorganic material, but is not limited thereto. The buffer layer BFL may be omitted according to a material, a process condition, and the like of the base layer BSL.

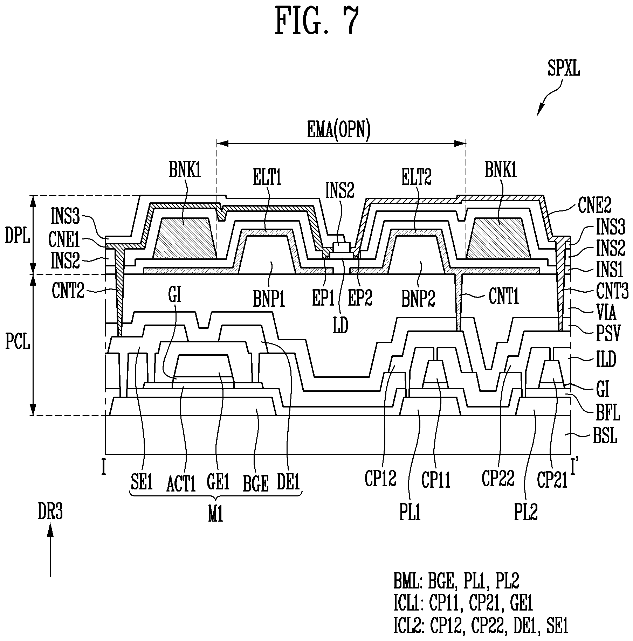

The active layer ACT may include a semiconductor. For example, the active layer ACT may include one or more of a group of polysilicon, low temperature polycrystalline silicon (LTPS), amorphous silicon, and an oxide semiconductor. According to one or more embodiments, the active layer ACT may form a channel of the first transistor M1, the second transistor M2, and the third transistor M3, and an impurity may be doped in a portion contacting source/drain electrodes (for example, a first source electrode SE1 and a first drain electrode DE1 of FIG. 7).

Each of the lower electrode layer BML, the first conductive layer ICL1, and the second conductive layer ICL2 may include a conductive material. For example, the conductive material may include one or more of a group of gold (Au), silver (Ag), aluminum (Al), molybdenum (Mo), chromium (Cr), titanium (Ti), nickel (Ni), neodymium (Nd), copper (Cu), and platinum (Pt). At least one of the lower electrode layer BML, the first conductive layer ICL1, and the second conductive layer ICL2 may include one or more conductive layers.

The gate insulating layer GI, the interlayer insulating layer ILD, the protective layer PSV, and the via layer VIA may be disposed between the respective layers to electrically separate the active layer ACT, the first conductive layer ICL1, the second conductive layer ICL2, and the alignment electrode layer ELT from each other. According to one or more embodiments, the above-described conductive layers may be electrically connected to each other through contact hole(s) formed in one or more of the gate insulating layer GI, the interlayer insulating layer ILD, the protective layer PSV, and the via layer VIA.

According to one or more embodiments, the gate insulating layer GI, the interlayer insulating layer ILD, and the protective layer PSV may include an inorganic material. However, embodiments of the present disclosure are not limited thereto, and the gate insulating layer GI, the interlayer insulating layer ILD, and the protective layer PSV may include an organic material. According to one or more embodiments, the via layer VIA may include an organic material. For example, the organic material may include one or more of a group of acrylic resin, epoxy resin, phenol resin, polyamide resin, polyimide resin, polyester resin, polyphenylenesulfide resin, and benzocyclobutene (BCB). However, the organic material of embodiments is not limited thereto.

According to one or more embodiments, the alignment electrode layer ELT may include a conductive material. For example, the alignment electrode layer ELT may include one or more of a group of molybdenum (Mo), magnesium (Mg), silver (Ag), platinum (Pt), palladium (Pd), gold (Au), nickel (Ni), neodymium (Nd), iridium (Ir), chromium (Cr), titanium (Ti), copper (Cu), and aluminum (Al).

According to one or more embodiments, the connection electrode layer CNE may include a conductive material. The connection electrode layer CNE may be electrically connected to the light emitting element LD. According to one or more embodiments, the connection electrode layer CNE may include a transparent conductive material. For example, the transparent conductive material may include one or more of a group of indium tin oxide (ITO), indium zinc oxide (IZO), zinc oxide (ZnO), and indium gallium zinc oxide, (IGZO). A first insulating layer INS1 (refer to FIG. 7) may be disposed between the alignment electrode layer ELT and the connection electrode layer CNE.

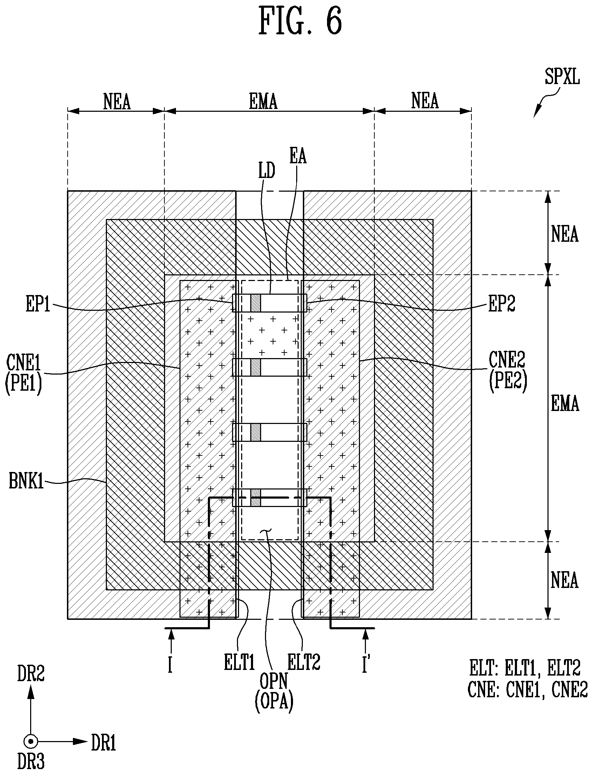

FIG. 6 is a plan view illustrating an embodiment of the sub-pixel included in the display device of FIG. 3. In FIG. 6, the sub-pixel SPXL is briefly shown based on the alignment electrode layer ELT and connection electrode layer CNE of FIG. 5.

The sub-pixel SPXL may include an emission area EMA and a non-emission area NEA. The sub-pixel SPXL may include a first bank BNK1, the alignment electrode layer ELT, the light emitting element LD, and the connection electrode layer CNE.

In a plan view, the emission area EMA may be defined by the first bank BNK1. For example, the emission area EMA may overlap an opening OPN (or an opening area OPA) of the first bank BNK1. The light emitting elements LD may be disposed in the emission area EMA. The light emitting elements LD may not be disposed in the non-emission area NEA.

The first bank BNK1 may have a shape protruding in a third direction DR3 and may be around (e.g., may surround) the emission area EMA. According to one or more embodiments, an ink including the light emitting element LD may be supplied to the opening OPN (or the opening area OPA) of the first bank BNK1, and thus the light emitting element LD may be disposed in the opening OPN. The first bank BNK1 may include an organic material.

The alignment electrode layer ELT may include electrodes for aligning the light emitting elements LD. According to one or more embodiments, the alignment electrode layer ELT may include a first electrode ELT1 (a first alignment electrode, or a first reflective electrode) and a second electrode ELT2 (a second alignment electrode, or a second reflective electrode). The first electrode ELT1 and the second electrode ELT2 may be spaced from each other in the first direction DR1 in the emission area EMA (or in the opening OPN of the first bank BNK1). For example, the first electrode ELT1 and the second electrode ELT2 may be spaced from each other by a length L (refer to FIG. 1) of the light emitting element LD or a distance corresponding thereto. For example, the first electrode ELT1 and the second electrode ELT2 may be spaced by about 4 µm. A space between the first electrode ELT1 and the second electrode ELT2 that are spaced from each other by the length L (refer to FIG. 1) of the light emitting element LD or the distance corresponding thereto in the emission area EMA (or in the opening OPN of the first bank BNK1) may be defined as a lane or passage (or an alignment area) in which the light emitting elements LD may be disposed.

In a process step in which the light emitting elements LD are aligned, a first alignment signal and a second alignment signal may be respectively applied to the first electrode ELT1 and the second electrode ELT2. For example, the ink including the light emitting element LD may be supplied to the opening OPN, the first alignment signal may be applied to the first electrode ELT1, and the second alignment signal may be applied to the second electrode ELT2. In this case, the first alignment signal and the second alignment signal may have different waveforms, potentials, and/or phases. For example, the first alignment signal may be an AC signal and the second alignment signal may be a ground signal. However, embodiments of the present disclosure are not limited thereto. An electric field may be formed between (or on) the first electrode ELT1 and the second electrode ELT2, and thus the light emitting elements LD may be aligned between the first electrode ELT1 and the second electrode ELT2 based on the electric field. For example, the light emitting elements LD may be moved (or rotated) by force (for example, dielectrophoresis (DEP) force) according to the electric field and thus may be aligned (or disposed) on the first electrode ELT1 and the second electrode ELT2.

The light emitting element LD may be disposed (or aligned) on the alignment electrode layer ELT. According to one or more embodiments, the light emitting element LD may be aligned between the first electrode ELT1 and the second electrode ELT2 in a plan view. The first end EP1 of the light emitting element LD may be disposed adjacent to the first electrode ELT1, and the second end EP2 of the light emitting element LD may be disposed adjacent to the second electrode ELT2. The light emitting elements LD may form (or configure) the light emitting unit EMU (refer to FIG. 4).

The light emitting element LD may emit light based on an electrical signal provided thereto. For example, the light emitting element LD may emit light based on a first electrical signal (for example, an anode signal) provided from the first connection electrode CNE1 and a second electrical signal (for example, a cathode signal) provided from the second connection electrode CNE2.

The connection electrode layer CNE may be disposed on the first ends EP1 and the second ends EP2 of the light emitting elements LD. According to one or more embodiments, the connection electrode layer CNE may include the first connection electrode CNE1 and the second connection electrode CNE2. The first connection electrode CNE1 may be the first pixel electrode PE1 (or the anode electrode), and the second connection electrode CNE2 may be the second pixel electrode PE2 (or the cathode electrode). The first connection electrode CNE1 may be disposed on the first ends EP1 to be electrically connected to the first ends EP1 of the light emitting elements LD. The second connection electrode CNE2 may be disposed on the second ends EP2 to be electrically connected to the second ends EP2 of the light emitting elements LD.

FIG. 7 is a cross-sectional view illustrating an embodiment of the sub-pixel taken along the line I-I' of FIG. 6. FIG. 7 shows the first transistor M1 and the first and second power lines PL1 and PL2 described with reference to FIG. 4 as an example of circuit elements that may be disposed in the pixel circuit layer PCL.

Referring to FIG. 7, the sub-pixel SPXL (or the display device) may include the pixel circuit layer PCL and a display element layer DPL (or a light emitting element layer) disposed on the base layer BSL.

The pixel circuit layer PCL may include the first transistor M1, the first power line PL1, the second power line PL2, and a plurality of insulating layers BFL, GI, ILD, PSV, and VIA. The first transistor M1 may include a lower electrode BGE, a first semiconductor pattern ACT1, a first gate electrode GE1, the first source electrode SE1 (a second transistor electrode, or a second terminal), and the first drain electrode DE1 (a first transistor electrode, or a first terminal).

The lower electrode layer BML may include the lower electrode BGE, the first power line PL1, and the second power line PL2. The lower electrode BGE and the first gate electrode GE1 of the first transistor M1 may overlap each other with the buffer layer BFL interposed therebetween. The lower electrode BGE may be disposed under the first semiconductor pattern ACT1 of the first transistor M1. At this time, the lower electrode BGE may serve as a light blocking pattern to stabilize an operation characteristic of the first transistor M1.

According to one or more embodiments, the first transistor M1 may not include the lower electrode BGE. At this time, the buffer layer BFL may be directly positioned on the base layer BSL. In addition, the lower electrode layer BML (e.g., the lower electrode BGE) may be physically and/or electrically connected to the first source electrode SE1 of the first transistor M1 through a contact hole of an insulating layer. Accordingly, the threshold voltage of the first transistor M1 may be moved in a negative direction or a positive direction.

The buffer layer BFL (or a first insulating layer) may cover the lower electrode layer BML and may be positioned on the base layer BSL.

The first semiconductor pattern ACT1 may be positioned on the buffer layer BFL. The first semiconductor pattern ACT1 may include a first area (for example, a source area) connected to the first source electrode SE1, a second area (for example, a drain area) connected to the first drain electrode DE1, and a channel area between the first and second areas. The channel area may overlap the first gate electrode GE1 of the first transistor M1.

The gate insulating layer GI (or a second insulating layer) may be disposed on the first semiconductor pattern ACT1. The gate insulating layer GI may be partially disposed on the first semiconductor pattern ACT1 or entirely disposed on the base layer BSL.

The first conductive layer ICL1 may be disposed on the gate insulating layer GI. The first conductive layer ICL1 may include the first gate electrode GE1, an eleventh connection pattern CP11, and a twenty-first connection pattern CP21.

The first gate electrode GE1 may be disposed on the gate insulating layer GI to overlap the channel area of the first semiconductor pattern ACT1 in a thickness direction of the base layer BSL (e.g., the third direction DR3). The eleventh connection pattern CP11 may overlap the first power line PL1 in the third direction DR3, and the twenty-first connection pattern CP21 may overlap the second power line PL2 in the third direction DR3.

The interlayer insulating layer ILD (e.g., a first interlayer insulating layer, or a third insulating layer) may cover the first conductive layer ICL1 and may be entirely disposed on the base layer BSL.

The second conductive layer ICL2 may be disposed on the interlayer insulating layer ILD. The second conductive layer ICL2 may include the first source electrode SE1, the first drain electrode DE1, a twelfth connection pattern CP12, and a twenty-second connection pattern CP22.

The first source electrode SE1 may contact or may be connected to the first area of the first semiconductor pattern ACT1 through a contact hole passing through the interlayer insulating layer ILD, and may contact or may be connected to the lower electrode BGE through a contact hole passing through the interlayer insulating layer ILD and the buffer layer BFL. The first drain electrode DE1 may contact or may be connected to the second area of the first semiconductor pattern ACT1 through a contact hole passing through the interlayer insulating layer ILD. Similarly, to the first source electrode SE1, the twelfth connection pattern CP12 may contact or may be connected to the first power line PL1 and the eleventh connection pattern CP11, and the twenty-second connection pattern CP22 may contact or may be connected to the second power line PL2 and the twenty-first connection pattern CP21. The eleventh connection pattern CP11 and the twelfth connection pattern CP12 may be connected to the first power line PL1 to reduce a resistance of the first power line PL1. Similarly, the twenty-first connection pattern CP21 and the twenty-second connection pattern CP22 may be connected to the second power line PL2 to reduce a resistance of the second power line PL2.

The protective layer PSV (or a second interlayer insulating layer) may be entirely disposed on the base layer BSL to cover the second conductive layer ICL2.

The via layer VIA (or a passivation layer) may be disposed on the protective layer PSV. The via layer VIA may be entirely disposed on the base layer BSL. The via layer VIA may provide a flat surface thereon.

The display element layer DPL may be positioned on the via layer VIA.

The display element layer DPL may include first and second bank patterns BNP1 and BNP2, the first and second electrodes ELT1 and ELT2 (alignment electrodes, or reflective electrodes), the first bank BNK1, the light emitting element LD, the first and second connection electrodes CNE1 and CNE2 (or contact electrodes), and a plurality of insulating layers INS1 to INS3.

The first and second bank patterns BNP1 and BNP2 may be disposed on the via layer VIA.

Each of the first and second bank patterns BNP1 and BNP2 may have a cross-section of a trapezoidal shape of which a width decreases from one surface (for example, an upper surface) of the via layer VIA toward an upper portion along the third direction DR3. According to one or more embodiments, each of the first and second bank patterns BNP1 and BNP2 may include a curved surface having a cross-section of a semi-elliptical shape, a semi-circular shape (or a hemispherical shape), or the like of which a width decreases from one surface of the via layer VIA toward an upper portion along the third direction DR3. In a cross-section, a shape of each of the first and second bank patterns BNP1 and BNP2 is not limited to the above-described embodiments, and may be variously changed within a range capable of improving efficiency of light emitted from each of the light emitting elements LD.

The first and second bank patterns BNP1 and BNP2 may include an inorganic material and/or an organic material and may be configured of a single layer or multiple layers. According to one or more embodiments, the first and second bank patterns BNP1 and BNP2 may be omitted. For example, a structure corresponding to the first and second bank patterns BNP1 and BNP2 may be formed in the via layer VIA.

The first and second electrodes ELT1 and ELT2 may be disposed on the via layer VIA and the first and second bank patterns BNP1 and BNP2.

The first electrode ELT1 may be disposed on the first bank pattern BNP1, and the second electrode ELT2 may be disposed on the second bank pattern BNP2. In a cross-section, the first and second electrodes ELT1 and ELT2 may have a surface profile respectively corresponding to the shapes of the first and second bank patterns BNP1 and BNP2.

Each of the first and second electrodes ELT1 and ELT2 may include a conductive material having a constant reflectance to allow the light emitted from the light emitting element LD to proceed in an image display direction (for example, the third direction DR3) of the display device. The first and second electrodes ELT1 and ELT2 may be configured of a single layer or multiple layers.

The second electrode ELT2 (or the first electrode ELT1) may contact or may be connected to the twelfth connection pattern CP12 through a first contact hole CNT1 passing through the via layer VIA and the protective layer PSV. The second electrode ELT2 (or the first electrode ELT1) may be electrically connected to the first power line PL1. The second electrode ELT2 may be directly connected to the twelfth connection pattern CP12, but embodiments are not limited thereto. For example, the second electrode ELT2 may be connected to the twelfth connection pattern CP12 (the eleventh connection pattern CP11, or the first power line PL1) through a bridge electrode.

The first insulating layer INS1 may be disposed on the via layer VIA to cover at least a portion of the first and second electrodes ELT1 and ELT2. The first insulating layer INS1 may be positioned between the first electrode ELT1 and the second electrode ELT2, and may prevent a short circuit between the first electrode ELT1 and the second electrode ELT2. The first insulating layer INS1 may include an inorganic material or an organic material.

The light emitting element LD may be disposed on the first insulating layer INS1. The light emitting element LD may be aligned between the first electrode ELT1 and the second electrode ELT2 so that the first end EP1 of the light emitting element LD faces the first electrode ELT1 and the second end EP2 of the light emitting element LD faces the second electrode ELT2.

The first end EP1 of the light emitting element LD may partially overlap the first electrode ELT1 in the third direction DR3, and the second end EP2 of the light emitting element LD may partially overlap the second electrode ELT2 in the third direction DR3. However, embodiments of the present disclosure are not limited thereto.

The first bank BNK1 may be disposed on the first insulating layer INS1. In a step of supplying the light emitting element LD on the first insulating layer INS1, the first bank BNK1 may be a dam structure that prevent a solution including the light emitting element LD from flowing into an adjacent sub-pixel SPXL or controls a certain amount of solution to be supplied to each sub-pixel SPXL. In addition, the first bank BNK1 may define the emission area EMA. For example, the emission area EMA may correspond to the opening OPN of the first bank BNK1.

The first bank BNK1 may include an organic material. According to one or more embodiments, the first bank BNK1 may include a light blocking material and/or a reflective material. In this case, the first bank BNK1 may prevent a light leakage defect in which light (or rays) leaks between the sub-pixel SPXL and a sub-pixel adjacent thereto. For example, the first bank BNK1 may include a color filter material or a black matrix material. As another example, a reflective material layer may be separately provided and/or formed on the first bank BNK1 to further improve efficiency of light emitted from the sub-pixel SPXL to an outside.

The second insulating layer INS2 (or a second insulating pattern) may be disposed on the light emitting element LD. The second insulating layer INS2 may be positioned on a portion of an upper surface of the light emitting element LD so that the first end EP1 and the second end EP2 of the light emitting element LD are exposed to the outside. According to one or more embodiments, the second insulating layer INS2 may also be disposed on the first insulating layer INS1 and the first bank BNK1.

According to a design condition or the like of the display device including the light emitting element LD, the second insulating layer INS2 may include an inorganic material or an organic material. After the alignment of the light emitting elements LD on the first insulating layer INS1 is completed, by positioning the second insulating layer INS2 on the light emitting element LD, the light emitting elements LD may be prevented from deviating from an aligned position. When an empty gap (or a space) exists between the first insulating layer INS1 and the light emitting element LD before forming the second insulating layer INS2, the empty gap may be filled with the second insulating layer INS2 in a process of forming the second insulating layer INS2.

The first connection electrode CNE1 may be disposed on the first electrode ELT1. The first connection electrode CNE1 may directly contact the first end EP1 of the light emitting element LD. The first connection electrode CNE1 may contact or may be connected to the first source electrode SE1 of the first transistor M1 through a second contact hole CNT2 passing through the second insulating layer INS2, the first insulating layer INS1, the via layer VIA, and the protective layer PSV. That is, the first connection electrode CNE1 may electrically connect the first end EP1 of the light emitting element LD and the first source electrode SE1 of the first transistor M1.

The third insulating layer INS3 may be positioned on the second insulating layer INS2 and the first connection electrode CNE1 to cover the second insulating layer INS2 and the first connection electrode CNE1. The third insulating layer INS3 may be positioned so that an edge contacts one end of the second insulating layer INS2, so that the second end EP2 of the light emitting element LD is exposed.

The third insulating layer INS3 may include an inorganic material or an organic material.

The second connection electrode CNE2 may be disposed on the second electrode ELT2. The second connection electrode CNE2 may directly contact the second end EP2 of the light emitting element LD. The second connection electrode CNE2 may contact or may be connected to the twenty-second connection pattern CP22 through a third contact hole CNT3 passing through the third insulating layer INS3, the second insulating layer INS2, the first insulating layer INS1, the via layer VIA, and the protective layer PSV. That is, the second connection electrode CNE2 may electrically connect the second end EP2 of the light emitting element LD and the second power line PL2.

A transparent conductive material (for example, ITO) may have excellent bonding strength with a conductive layer (for example, the first source electrode SE1 and the twenty-second connection pattern CP22) in the pixel circuit layer PCL and may have a low contact resistance in comparison with a conductive material having a specific reflectance. Therefore, the first and second connection electrodes CNE1 and CNE2 may be directly connected to a configuration in the pixel circuit layer PCL without passing through the first and second electrodes ELT1 and ELT2. However, embodiments of the present disclosure are not limited thereto.

Although the first connection electrode CNE1 and the second connection electrode CNE2 are positioned on different layers with the third insulating layer INS3 interposed therebetween in FIG. 7, embodiments of the present disclosure are not limited thereto. For example, the first connection electrode CNE1 and the second connection electrode CNE2 may be disposed on the same layer (for example, the second insulating layer INS2) through the same process.

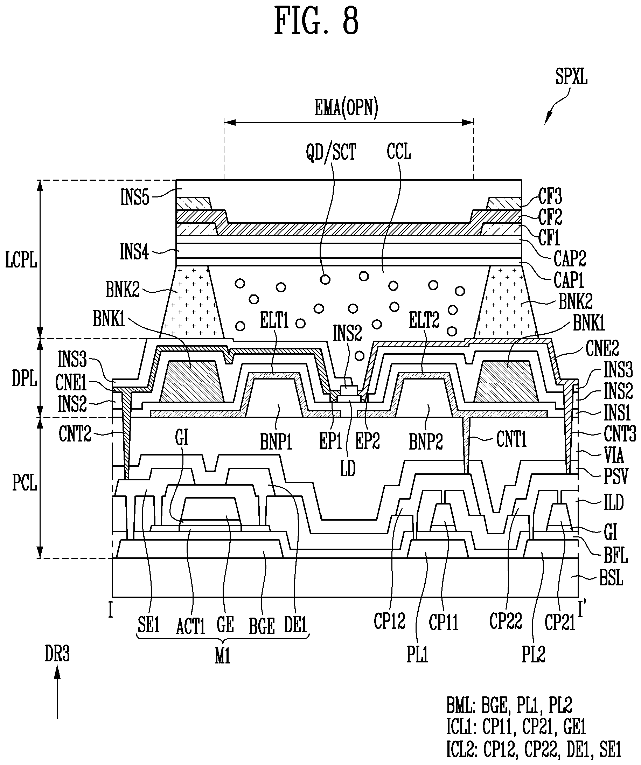

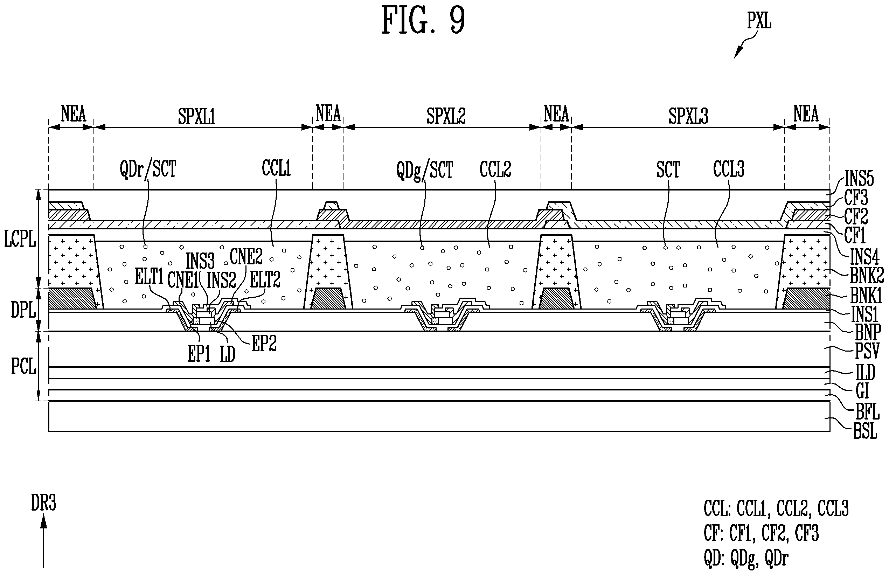

FIG. 8 is a cross-sectional view illustrating an embodiment of the sub-pixel taken along the line I-I' of FIG. 6. FIG. 9 is a cross-sectional view illustrating an embodiment of the pixel included in the display device of FIG. 3.

Referring to FIGS. 7 and 8, the sub-pixel SPXL (or the display device) may further include a light conversion layer LCPL disposed on the display element layer DPL.

The light conversion layer LCPL may further include a second bank BNK2, a color conversion layer CCL, and color filters CF1 to CF3.

The second bank BNK2 may be disposed on the display element layer DPL. The second bank BNK2 may be positioned in the non-emission area NEA (FIG. 6) and may be a structure defining a position where the color conversion layer CCL is to be supplied. The second bank BNK2 may overlap the first bank BNK1 in the third direction DR3.

The second bank BNK2 may include an organic material. According to one or more embodiments, the second bank BNK2 may include a light blocking material. For example, the second bank BNK2 may be a black matrix. According to one or more embodiments, the second bank BNK2 may be configured to include at least one light blocking material and/or reflective material to allow light emitted from the color conversion layer CCL to further proceed in the image display direction (or the third direction DR3), thereby improving light emission efficiency of the color conversion layer CCL.

The color conversion layer CCL may be disposed on the display element layer DPL (or the light emitting element LD) in an area surrounded by the second bank BNK2.

The color conversion layer CCL may include color conversion particles QD (or wavelength conversion particles) corresponding to a specific color. For example, the color conversion layer CCL may include the color conversion particles QD converting light of a first color (or a first wavelength band) incident from the light emitting element LD into light of a second color (a specific color, or a second wavelength band) and emitting the light of the second color.

Referring to FIG. 9, when the first sub-pixel SPXL1 is a red pixel (or a red sub-pixel), a first color conversion layer CCL1 of the first sub-pixel SPXL1 may include first color conversion particles QDr of a red quantum dot converting light of a first color emitted from the light emitting element LD into light of a second color, for example, red light.

When the second sub-pixel SPXL2 is a green pixel (or a green sub-pixel), the second color conversion layer CCL2 of the second sub-pixel SPXL2 may include second color conversion particles QDg of a green quantum dot converting the light of the first color emitted from the light emitting element LD into light of a third color, for example, green light.

When the third sub-pixel SPXL3 is a blue pixel (or a blue sub-pixel), the third color conversion layer CCL3 of the third sub-pixel SPXL3 may include color conversion particles of a blue quantum dot converting the light of the first color emitted from the light emitting element LD into light of a fourth color, for example, blue light.

According to one or more embodiments, when the third sub-pixel SPXL3 is the blue pixel (or the blue sub-pixel) and the light emitting element LD emits blue-based light, the third sub-pixel SPXL3 may include a light scattering layer including light scattering particles SCT. The first sub-pixel SPXL1 and the second sub-pixel SPXL2 may also include a light scattering layer including light scattering particles SCT. The light scattering layer described above may be omitted according to one or more embodiments. According to one or more embodiments, when the third sub-pixel SPXL3 is the blue pixel (or the blue sub-pixel), a transparent polymer may be provided instead of the third color conversion layer CCL3.

Referring to FIG. 8 again, a fourth insulating layer INS4 may be disposed on the color conversion layer CCL and the second bank BNK2.

The fourth insulating layer INS4 may be provided on the entire base layer BSL to cover the second bank BNK2 and the color conversion layer CCL. The fourth insulating layer INS4 may include an inorganic material or an organic material. According to one or more embodiments, the fourth insulating layer INS4 may totally reflect the light emitted from the color conversion layer CCL (for example, light proceeding in an oblique direction) by using a refractive index difference from an adjacent configuration, and improve light emission efficiency of the sub-pixel SPXL. To this end, the fourth insulating layer INS4 may have a relatively low refractive index compared to the color conversion layer CCL.

According to one or more embodiments, the fourth insulating layer INS4 may have a flat surface and alleviate a step difference generated by components disposed thereunder.

In one or more embodiments, first and second capping layers CAP1 and CPA2 may be disposed on and under the fourth insulating layer INS4. The first and second capping layers CAP1 and CPA2 may include an inorganic material. The first capping layer CAP1 may be disposed on the color conversion layer CCL, and may prevent penetration of moisture (or a solution used in a subsequent process) into the lower color conversion layer CCL. The second capping layer CAP2 may be disposed on the fourth insulating layer INS4, and may prevent penetration of moisture into the fourth insulating layer INS4. According to one or more embodiments, the second capping layer CAP2 may improve adhesion between the fourth insulating layer INS4 and a color filter layer.

The color filter layer may be disposed on the fourth insulating layer INS4.

Referring to FIG. 9, the color filter layer may include a color filter CF corresponding to each color of adjacent sub-pixels. For example, a first color filter CF1 may be disposed on a first color conversion layer CCL1 of the first sub-pixel SPXL1, a second color filter CF2 may be disposed on a second color conversion layer CCL2 of the second sub-pixel SPXL2, and a third color filter CF3 may be disposed on a third color conversion layer CCL3 of the third sub-pixel SPXL3. Each of the first, second, and third color filters CF1, CF2, and CF3 may include a color filter material that selectively transmits light of a specific color converted in the color conversion layer CCL. For example, the first color filter CF1 may be a red color filter, the second color filter CF2 may be a green color filter, and the third color filter CF3 may be a blue color filter. The above-described color filter CF may be provided on one surface of the fourth insulating layer INS4 to correspond to the color conversion layer CCL.

The first, second, and third color filters CF1, CF2, and CF3 may be disposed to overlap each other in the non-emission area NEA to block light interference between adjacent sub-pixels. According to one or more embodiments, a separate light blocking pattern may be disposed in the non-emission area NEA instead of a stack structure of the first, second, and third color filters CF1, CF2, and CF3.

A fifth insulating layer INS5 may be disposed on the color filter layer. The fifth insulating layer INS5 may include an inorganic material or an organic material. The fifth insulating layer INS5 may entirely cover configurations positioned thereunder to block water, moisture, or the like from entering the color filter layer and the display element layer DPL from the outside. In one or more embodiments, the fifth insulating layer INS5 may be formed of multiple layers. For example, the fifth insulating layer INS5 may include at least two inorganic layers and at least one organic layer interposed between the at least two inorganic layers. However, a configuration material and/or a structure of the fifth insulating layer INS5 may be variously changed. In addition, according to one or more embodiments, at least one layer of overcoat layer, a filler layer, an upper substrate, and/or the like may be further disposed on the fifth insulating layer INS5.

In the above-described embodiment, the color conversion layer CCL is directly formed on the display element layer DPL, but embodiments are not limited thereto. According to one or more embodiments, the color conversion layer CCL may be formed on a separate substrate and bonded to the display element layer DPL through an adhesive material.

When the sub-pixel SPXL includes the light conversion layer LCPL on the display element layer DPL, that is, when the sub-pixel SPXL includes the color conversion layer CCL and the color filter CF disposed on the light emitting element LD, light having excellent color reproducibility may be emitted through the color conversion layer CCL and the color filter CF, and light emission efficiency of the sub-pixel SPXL may be improved.

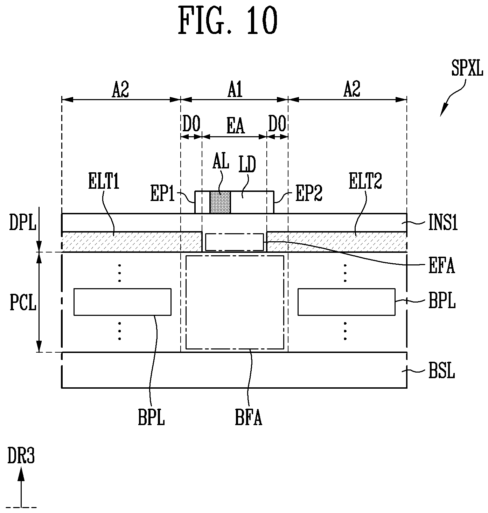

FIG. 10 is a schematic cross-sectional view illustrating a disposition relationship between an alignment electrode layer and lower lines according to one or more embodiments.

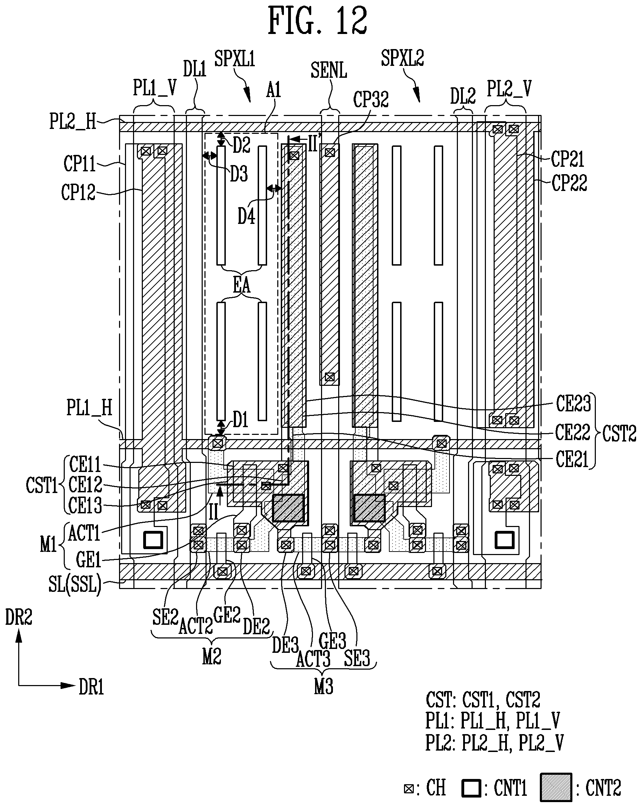

Referring to FIG. 10, the sub-pixel SPXL (or the display device) may include a first area A1 and a second area A2. The first area A1 may be an area set largely by a suitable distance (e.g., a predetermined distance) D0 based on the lane EA. The first area A1 may be set to be larger than the lane EA by the distance D0 in all directions of up, down, left, and right directions in a plan view (refer to FIG. 12). The distance D0 may be half or more of the length L of the light emitting element LD (refer to FIG. 1), and for example, the distance D0 may be about 6 µm or more.

The lower lines BPL (or conductive patterns) according to one or more embodiments may be disposed (or patterned) in one area of the pixel circuit layer PCL. For example, the lower lines BPL may be disposed in the second area A2 and may not be disposed in the first area A1. For example, one or more of the lower electrode layer BML, the first conductive layer ICL1, and the second conductive layer ICL2 may be disposed in the second area A2. Some of the lower lines BPL may be interconnected through a contact hole passing through a portion of the insulating layers or may be connected to another configuration (for example, the first electrode ELT1 or the second electrode ELT2). The contact hole may be disposed in the second area A2 and may not be disposed in the first area A1.

The lower lines BPL may be selectively disposed only in some areas, and thus the pixel circuit layer PCL may include a line-free area BFA in which the lower lines BPL are not disposed. For example, in a plan view, the line-free area BFA may overlap the first area A1 and may not overlap the lower lines BPL and the second area A2. Accordingly, in a plan view, the lane EA may not overlap all lower lines BPL (and the contact hole) of the pixel circuit layer PCL, and the lane EA may be spaced from all lower lines BPL (and the contact hole) by a distance equal to or greater than half of the length L of the light emitting element LD. In the line-free area BFA, only insulating layer(s) (for example, one or more of the buffer layer BFL, the gate insulating layer GI, the interlayer insulating layer ILD, the protective layer PSV, and the via layer VIA) may be disposed on the base layer BSL in the pixel circuit layer PCL.

The alignment electrode layer ELT may be disposed (or patterned) in one area of the display element layer DPL. For example, the alignment electrode layer ELT may be disposed in the second area A2. For example, the first electrode ELT1 and the second electrode ELT2 may be disposed in the second area A2. In the first area A1, the first electrode ELT1 and the second electrode ELT2 may be spaced from each other.

The first electrode ELT1 and the second electrode ELT2 may be selectively disposed in only a partial area of the first area A1 to form an electrode-free area EFA. For example, the electrode-free area EFA may be an area defined by spacing the first electrode ELT1 and the second electrode ELT2 apart from each other. According to one or more embodiments, the electrode-free area EFA may be entirely covered by the line-free area BFA in a plan view.

In a plan view, the electrode-free area EFA may overlap the light emitting element LD. According to one or more embodiments, the electrode-free area EFA may overlap the active layer AL of the light emitting element LD. For example, the electrode-free area EFA may correspond to the lane EA (or an alignment area) in which the light emitting element LD is arranged between the first electrode ELT1 and the second electrode ELT2.

According to one or more embodiments, the light emitting element LD may be aligned based on the electric field formed between the first electrode ELT1 and the second electrode ELT2. Experimentally, when the lower lines BPL (and the contact hole) are formed in the lane EA, the electric fields formed between the first electrode ELT1 and the second electrode ELT2 may be interfered by the lower lines BPL, and thus an alignment degree of the light emitting element LD and reliability of the alignment may be reduced. For example, the light emitting element LD may not be aligned at a center of the lane EA and may be disposed biasedly to one of the first electrode ELT1 and the second electrode ELT2. In addition, when the lower lines BPL are formed in the first area A1, for example, when the lower lines BPL are adjacent to the lane EA by the length L (refer to FIG. 1) of the light emitting element LD, the electric fields may be interfered by the lower lines BPL. Therefore, the lower lines BPL (and the contact hole) are not disposed in the first area A1, and in this case, an influence on electrical signals (for example, the electric field, and the like) for aligning the light emitting element LD may be reduced, and consequently, the alignment degree of the light emitting elements LD may be substantially improved. That is, the light emitting elements LD may be more uniformly arranged.

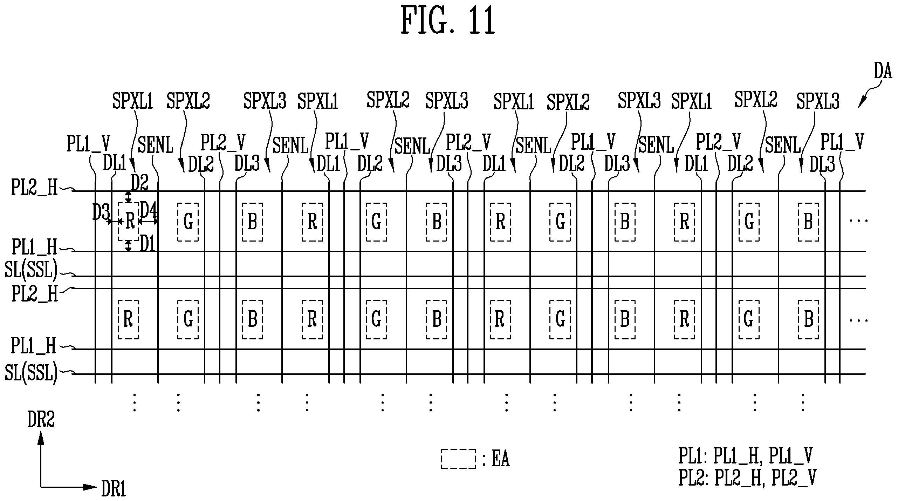

FIG. 11 is a plan view illustrating an embodiment of the display device of FIG. 3. FIG. 11 shows an arrangement of the lanes EA and the lines DL1 to DL3, PL1, PL2, SENL, and SL of the sub-pixels SPXL1 to SPXL3 in the display area DA.

Referring to FIG. 11, the sub-pixels SPXL1 to SPXL3 may be sequentially and repeatedly arranged along the first direction DR1. The first sub-pixel SPXL1 may be a red pixel R, the second sub-pixel SPXL2 may be a green pixel G, and the third sub-pixel SPXL3 may be a blue pixel B, but embodiments of the present disclosure are not limited thereto. In addition, the sub-pixels SPXL1 to SPXL3 may be repeatedly arranged along the second direction DR2.

The lines DL1 to DL3, PL1, PL2, SENL, and SL may be spaced from the lane EA of each of the sub-pixels SPXL1 to SPXL3 by suitable distances (e.g., predetermined distances) D1 to D4. As described with reference to FIG. 10, the distances D1 to D4 are equal to or greater than half of the length L of the light emitting element LD (refer to FIG. 1), and for example, the distances D1 to D4 may be about 6 µm or more.

Each of data lines DL1 to DL3 may extend in the second direction DR2 and may be sequentially and repeatedly arranged along the first direction DR1 in correspondence with the sub-pixels SPXL1 to SPXL3. For example, a first data line DL1 may be disposed on a left side (or a right side) of the lane EA of the first sub-pixel SPXL1. The first data line DL1 may be spaced from the lane EA of the first sub-pixel SPXL1 by a third distance D3. A second data line DL2 may be disposed spaced from the lane EA of the second sub-pixel SPXL2 by a third distance D3 on the right side (or the left side) of the lane EA of the second sub-pixel SPXL2, and the third data line DL3 may be disposed spaced from the lane EA of the third sub-pixel SPXL3 by the third distance D3 on the left side (or the right side) of the lane EA of the third sub-pixel SPXL3.

The sensing line SENL (or a first line) may extend in the second direction DR2 and may be repeatedly arranged along the first direction DR1 with a distance corresponding to two sub-pixels. For example, the sensing line SENL may be disposed between the first sub-pixel SPXL1 of a first column and the second sub-pixel SPXL2 of a second column, and may be spaced from the lane EA of the first sub-pixel SPXL1 (and the second sub-pixel SPXL2) by a fourth distance D4. The first sub-pixel SPXL1 and the second sub-pixel SPXL2 adjacent to each other with the sensing line SENL interposed therebetween may share the sensing line SENL and have a mutually symmetrical structure with respect to the sensing line SENL. The mutually symmetrical structure is described later with reference to FIG. 12. Similarly, the sensing line SENL may be disposed between the third sub-pixel SPXL3 of a third column and the first sub-pixel SPXL1 of a fourth column, and the third sub-pixel SPXL3 of the third column and the first sub-pixel SPXL1 of the fourth column may have a mutually symmetrical structure with respect to the sensing line SENL interposed therebetween.

The first power line PL1 may include a first horizontal power line PL1_H and a first vertical power line PL1_V. The first horizontal power line PL1_H and the first vertical power line PL1_V may cross each other and may be electrically connected to each other. The first power line PL1 including the first horizontal power line PL1_H and the first vertical power line PL1_V may be arranged in a mesh shape throughout the display area DA. The first vertical power line PL1_V may be a main power line, and the first horizontal power line PL1_H may be an auxiliary power line, but embodiments of the present disclosure are not limited thereto.

The first vertical power line PL1_V may extend in the second direction DR2 and may be repeatedly arranged along the first direction DR1 with a distance corresponding to four sub-pixels. For example, the first vertical power line PL1_V may be disposed on a left side of the first sub-pixel SPXL1 of the first column. In addition, the first vertical power line PL1_V may be disposed between the first sub-pixel SPXL1 of the fourth column and the second sub-pixel SPXL2 of a fifth column.

The first horizontal power line PL1_H may extend in the first direction DR1 and may be arranged in a row unit along the second direction DR2. For example, the first horizontal power line PL1_H may be disposed spaced from the lane EA of the first sub-pixel SPXL1 of a first row by a first distance D1 on a lower side. Similarly, the first horizontal power line PL1_H may be disposed spaced apart from the lane EA of each of the sub-pixels SPXL1 to SPXL3 of a second row on the lower side.

Similarly, to the first power line PL1, the second power line PL2 may include a second horizontal power line PL2_H and a second vertical power line PL2_V. The second horizontal power line PL2_H and the second vertical power line PL2_V may be electrically connected to each other, and the second power line PL2 may be arranged in a mesh shape throughout the display area DA. The second vertical power line PL2_V may be a main power line, and the second horizontal power line PL2_H may be an auxiliary power line, but embodiments of the present disclosure are not limited thereto.

The second vertical power line PL2_V may extend in the second direction DR2, may be spaced from the first vertical power line PL1_V in the first direction DR1 by a distance corresponding to two sub-pixels, and may be repeatedly arranged along the first direction DR1 with a distance corresponding to four sub-pixels. For example, the second vertical power line PL2_V may be disposed between the second sub-pixel SPXL2 of the second column and the third sub-pixel SPXL3 of the third column. In addition, the second vertical power line PL2_V may be disposed between the third sub-pixel SPXL3 of a sixth column and the first sub-pixel SPXL1 of a seventh column.

The second horizontal power line PL2_H may extend in the first direction DR1 and may be arranged in a row unit along the second direction DR2. For example, the second horizontal power line PL2_H may be disposed spaced from the lane EA of the first sub-pixel SPXL1 of the first row by a second distance D2 on an upper side. Similarly, the second horizontal power line PL2_H may be disposed spaced from the lane EA of each of the sub-pixels SPXL1 to SPXL3 of the second row on the upper side.

The scan line SL (and/or the sensing scan lines SSL) may extend in the first direction DR1 and may be arranged in a row unit along the second direction DR2.

In one row, 12 sub-pixels may configure a unit block according to an arrangement of the sub-pixels SPXL1 to SPXL3 and an arrangement of vertical lines DL1 to DL3, PL1_V, and PL2_V, and the display device may have a structure in which the unit block is repeated.

As described above, the lines DL1 to DL3, PL1, PL2, SENL, and SL may be disposed spaced from the lane EA of each of the sub-pixels SPXL1 to SPXL3 by the distances D1 to D4.

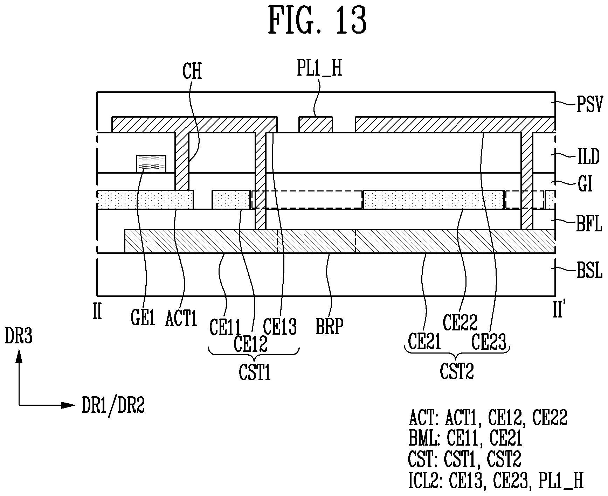

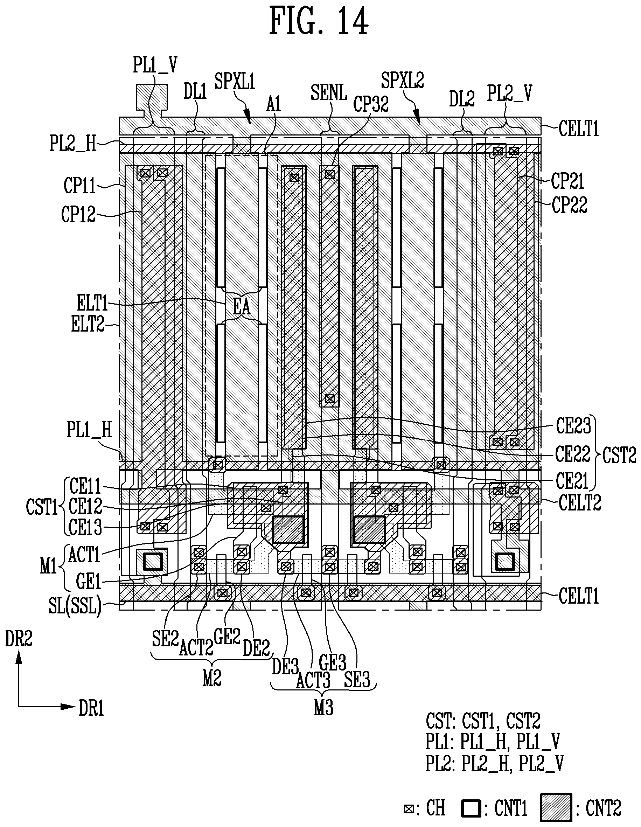

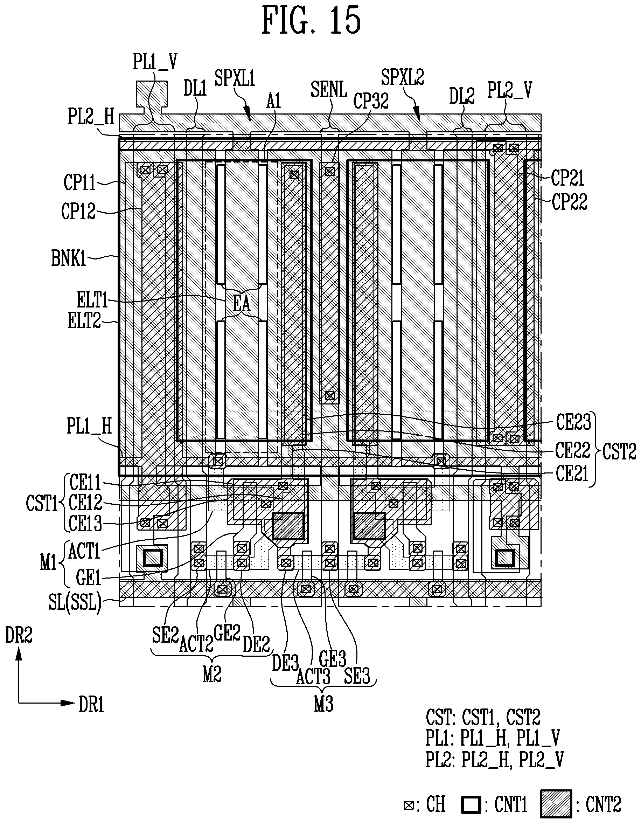

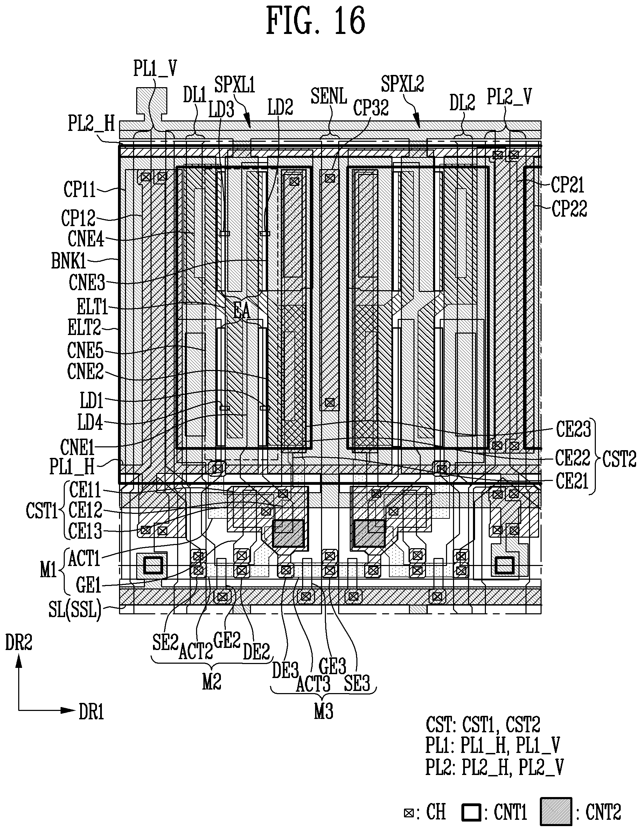

FIG. 12 is a layout diagram illustrating an embodiment of the first and second sub-pixels included in the display device of FIG. 11. FIG. 12 shows the first sub-pixel SPXL1 of the first column and the second sub-pixel SPXL2 of the second column of FIG. 11 based on the pixel circuit layer PCL (refer to FIG. 7). FIG. 13 is a cross-sectional view illustrating an embodiment of a storage capacitor taken along the line II-II' of FIG. 12. FIGS. 14, 15, and 16 are layout diagrams illustrating an embodiment of the first and second sub-pixels included in the display device of FIG. 11. FIG. 14 further shows the first electrode ELT1 and the second electrode ELT2, FIG. 15 further shows the first bank BNK1, and FIG. 16 further shows the connection electrodes CNE1 to CNE5.

Referring to FIGS. 11 to 16, the second sub-pixel SPXL2 may have a structure symmetrical to the first sub-pixel SPXL1 with respect to the sensing line SENL. That is, transistors, a capacitor, and the like of the second sub-pixel SPXL2 may be arranged to be symmetrical to transistors, a capacitor, and the like of the first sub-pixel SPXL1 with respect to the sensing line SENL. In one or more embodiments, the third sub-pixel SPXL3 of the third column and the first sub-pixel SPXL1 of the fourth column of FIG. 11 may have a structure symmetrical to the second sub-pixel SPXL2 and the first sub-pixel SPXL1 of FIG. 12 with respect to the second vertical power line PL2_V. Therefore, a common configuration of the sub-pixels SPXL1 to SPXL3 of FIG. 11 is described based on the first sub-pixel SPXL1, and an overlapping description is not repeated.

Each of the first vertical power line PL1_V, the first data line DL1, the sensing line SENL, the second data line DL2, and the second vertical power line PL2_V may generally extend in the second direction DR2 and may be arranged along the first direction DR1. The first vertical power line PL1_V, the first data line DL1, the sensing line SENL, the second data line DL2, and the second vertical power line PL2_V may be included in the lower electrode layer BML described with reference to FIGS. 5 and 7, and may be disposed on the same layer through the same process.

The second horizontal power line PL2_H, the first horizontal power line PL1_H, and the scan line SL may generally extend in the first direction DR1 and may be arranged along the second direction DR2. The second horizontal power line PL2_H, the first horizontal power line PL1_H, and the scan line SL may be included in the second conductive layer ICL2 described with reference to FIGS. 5 and 7, and may be disposed on the same layer through the same process.

The first vertical power line PL1_V and the first horizontal power line PL1_H may configure the first power line PL1. Similarly, the second vertical power line PL2_V and the second horizontal power line PL2_H may configure the second power line PL2. Each of the first power line PL1 and the second power line PL2 may be arranged in a mesh shape, and in this case, each of the first power line PL1 and the second power line PL2 may be reduced.

In addition, each of the first power line PL1 and the second power line PL2 may have a three-layer structure (that is, a structure including three conductive layers). The eleventh connection pattern CP11 may overlap the first vertical power line PL1_V in an area between the second horizontal power line PL2_H and the scan line SL, and may be connected to the first vertical power line PL1_V through a contact hole CH. The twelfth connection pattern CP12 may expand or extend from the first horizontal power line PL1_H in the first direction DR1, may overlap the first vertical power line PL1_V, and may be connected to the first vertical power line PL1_V through the contact hole CH. Similarly, the twenty-first connection pattern CP21 and the twenty-second connection pattern CP22 may overlap the second vertical power line PL2_V and may be connected to the second vertical power line PL2_V through the contact hole CH. In this case, a resistance of each of the first power line PL1 and the second power line PL2 may be further reduced.

The sensing line SENL may have a two-layer structure. A thirty-second connection pattern CP32 may overlap the sensing line SENL and may be connected to the sensing line SENL through the contact hole CH. However, embodiments of the present disclosure are not limited thereto, and for example, the sensing line SENL may have a three-layer structure.

The first area A1 may be positioned in an area (or a pixel area) partitioned by the data line DL1 or DL2, the sensing line SENL (or a second storage capacitor CST2), the first horizontal power line PL1_H, and the second horizontal power line PL2_H. The first area A1 may include the lane EA (that is, a space between the first electrode ELT1 and the second electrode ELT2 that are spaced from each other in an opening of the first bank BNK1 of FIG. 15).

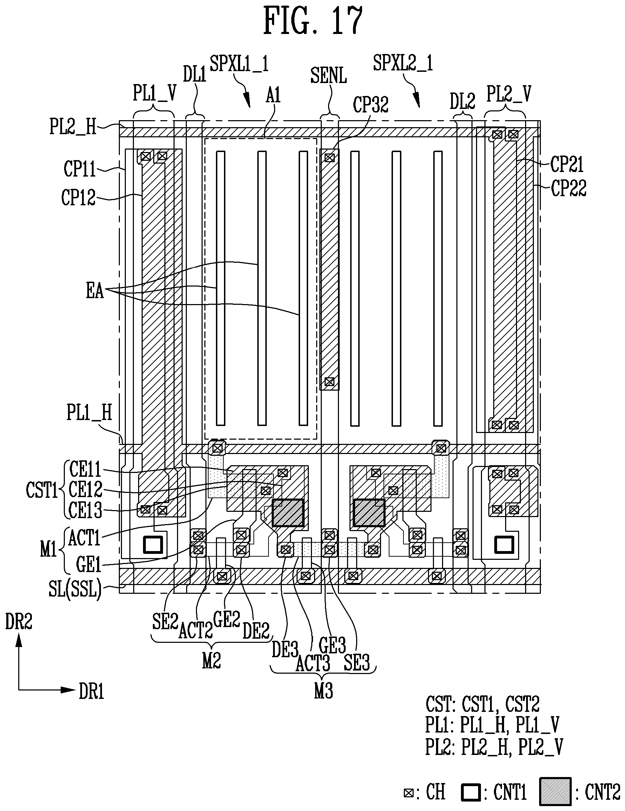

The lane EA in the first area A1 may be spaced from the first horizontal power line PL1_H (and the contact hole CH) by the first distance D1 in the second direction DR2, may be spaced from the second horizontal power line PL2_H by the second distance D2 in the second direction DR2, may be spaced from the first data line DL1 by the third distance D3 in the first direction DR1, and may be spaced from the second storage capacitor CST2 by the fourth distance D4 in the first direction DR1 (e.g., see FIGS. 11 to 15). The lane EA in the first area A1 may be spaced from the sensing line SENL by the fourth distance D4 or more in the first direction DR1. The second storage capacitor CST2 may configure the storage capacitor CST together with a first storage capacitor CST1. According to one or more embodiments, the second storage capacitor CST2 may be omitted (refer to FIG. 17). According to one or more embodiments, the first storage capacitor CST1 may be omitted instead of the second storage capacitor CST2.

The pixel circuit including the transistors M1 to M3 and the first storage capacitor CST1 may be positioned in the second direction DR2 from the first area A1. For example, the transistors M1 to M3 and the first storage capacitor CST1 may be positioned in an area between the first horizontal power line PL1_H and the scan line SL (and between the data line DL1 or DL2 and the sensing line SENL).

The first semiconductor pattern ACT1 may protrude from the first horizontal power line PL1_H in the second direction DR2 and extend in the first direction DR1. The first semiconductor pattern ACT1 may configure the first transistor M1. One end of the first semiconductor pattern ACT1 may be connected to the first horizontal power line PL1_H through the contact hole CH. As shown in FIG. 13, another end of the first semiconductor pattern ACT1 may overlap a thirteenth capacitor electrode CE13 of the first storage capacitor CST1 in the third direction DR3, and may be connected to the thirteenth capacitor electrode CE13 through the contact hole CH.

Referring to FIG. 13, an eleventh capacitor electrode CE11 of the first storage capacitor CST1 may be included in the lower electrode layer BML, a twelfth capacitor electrode CE12 may be included in the active layer ACT, and the thirteenth capacitor electrode CE13 may be included in the second conductive layer ICL2. The twelfth capacitor electrode CE12 may be a semiconductor pattern doped with an impurity. The eleventh capacitor electrode CE11 and the twelfth capacitor electrode CE12 may overlap to configure a first sub-capacitor, and the twelfth capacitor electrode CE12 and the thirteenth capacitor electrode CE13 may overlap to configure a second sub-capacitor. The thirteenth capacitor electrode CE13 may be connected to the eleventh capacitor electrode CE11 through the contact hole CH, and thus the first sub-capacitor and the second sub-capacitor may be connected in parallel to configure the first storage capacitor CST1. Therefore, within a limited space in a plan view, a capacity of the first storage capacitor CST1 may be secured more sufficiently.

Referring to FIG. 12 again, one end of the first gate electrode GE1 may overlap the channel area of the first semiconductor pattern ACT1. Another end of the first gate electrode GE1 may be connected to a second drain electrode DE2 of the second transistor M2 through the contact hole CH.

A second semiconductor pattern ACT2 may extend from the first data line DL1 in the first direction DR1. The second semiconductor pattern ACT2 may configure the second transistor M2. One end of the second semiconductor pattern ACT2 may be connected to a second source electrode SE2 through the contact hole CH, and the second source electrode SE2 may be connected to the first data line DL1 through the contact hole CH. Another end of the second semiconductor pattern ACT2 may be connected to the second drain electrode DE2 through the contact hole CH. One end of a second gate electrode GE2 may overlap a channel area of the second semiconductor pattern ACT2, and another end of the second gate electrode GE2 may be connected to the scan line SL through the contact hole CH.

The second semiconductor pattern ACT2 may further extend in the first direction DR1 and may configure the twelfth capacitor electrode CE12 of the first storage capacitor CST1.

A third semiconductor pattern ACT3 may extend in the first direction DR1 from the sensing line SENL. The third semiconductor pattern ACT3 may configure the third transistor M3. The third semiconductor pattern ACT3 may be connected to a third source electrode SE3 through the contact hole CH, and the third source electrode SE3 may be connected to the sensing line SENL through the contact hole CH. One end of the third semiconductor pattern ACT3 may be connected to a third drain electrode DE3 through the contact hole CH. The third drain electrode DE3 may be integrally formed with the thirteenth capacitor electrode CE13, but embodiments are not limited thereto. One end of a third gate electrode GE3 may overlap a channel area of the third semiconductor pattern ACT3, and another end of the third gate electrode GE3 may be connected to the scan line SL (or the sensing scan line SSL) through the contact hole CH.

As shown in FIG. 12, the third semiconductor pattern ACT3 may configure not only the third transistor M3 of the first sub-pixel SPXL1 but also the third transistor M3 of the second sub-pixel SPXL2. The sensing line SENL may be commonly connected to the first sub-pixel SPXL1 and the second sub-pixel SPXL2. When the first sub-pixel SPXL1 and the second sub-pixel SPXL2 share the sensing line SENL, a width or a distance of the first direction DR1 of each of the first sub-pixel SPXL1 and the second sub-pixel SPXL2 may be reduced, or the first area A1 may be more sufficiently secured, in comparison with a case where the sensing line SENL is provided to each of the first sub-pixel SPXL1 and the second sub-pixel SPXL2 (that is, a total of two sensing lines). In addition, as described with reference to FIG. 11, because each of the first vertical power line PL1_V and the second vertical power line PL2_V are arranged at the distance of four sub-pixels , the first area A1 may be more sufficiently secured. In other words, the lane EA may be more sufficiently spaced from surrounding lines DL1, PL1, PL2, and SENL.

In one or more embodiments, the storage capacitors CST may include the first storage capacitor CST1 and the second storage capacitor CST2 that are spaced in the second direction DR2 with the first horizontal power line PL1_H interposed therebetween in a plan view. The first storage capacitor CST1 and the second storage capacitor CST2 may be electrically connected in parallel.

The twelfth capacitor electrode CE12 (or the second semiconductor pattern ACT2) may further extend in the second direction DR2 across the first horizontal power line PL1_H, and may be connected to a twenty-second capacitor electrode CE22 of the second storage capacitor CST2. The twenty-second capacitor electrode CE22 may be integrally formed with the twelfth capacitor electrode CE12.

Referring to FIG. 13, a twenty-first capacitor electrode CE21 of the second storage capacitor CST2 may be included in the lower electrode layer BML, and may be connected to the eleventh capacitor electrode CE11 through a bridge pattern BRP. The twenty-first capacitor electrode CE21, the bridge pattern BRP, and the eleventh capacitor electrode CE11 may be integrally formed. A twenty-second capacitor electrode CE22 may be included in the active layer ACT, and a twenty-third capacitor electrode CE23 may be included in the second conductive layer ICL2. The twenty-second capacitor electrode CE22 may be a semiconductor pattern doped with an impurity. The twenty-first capacitor electrode CE21 and the twenty-second capacitor electrode CE22 may overlap in the third direction DR3 to configure a third sub-capacitor, and the twenty-second capacitor electrode CE22 and the twenty-third capacitor electrode CE23 may overlap in the third direction DR3 to configure a fourth sub-capacitor. The twenty-third capacitor electrode CE23 may be connected to the twenty-first capacitor electrode CE21 through the contact hole CH, and thus the third sub-capacitor and the fourth sub-capacitor may be connected in parallel to configure the second storage capacitor CST2. Because the storage capacitor CST further includes the second storage capacitor CST2 in addition to the first storage capacitor CST1, a capacity of the storage capacitor CST may be sufficiently secured.

Although it has been described that the twenty-second capacitor electrode CE22 is included in the active layer ACT, the twenty-second capacitor electrode CE22 is not limited thereto. For example, the twenty-second capacitor electrode CE22 may be included in the first conductive layer between the gate insulating layer GI and the interlayer insulating layer ILD. However, when the twenty-second capacitor electrode CE22 (and a portion connected to the twelfth capacitor electrode CE12) is positioned in the active layer ACT, a short circuit between the storage capacitor CST and the first horizontal power line PL1_H may be prevented by two insulating layers (that is, the gate insulating layer GI and the interlayer insulating layer ILD).

For reference, in order to additionally form the second storage capacitor CST2, the scan line SL (the second transistor M2, and the third transistor M3 connected thereto) may be disposed spaced from the first area A1 (that is, the first area A1 of a corresponding sub-pixel). When the first storage capacitor CST1 and the second storage capacitor CST2 are divided based on the scan line SL, the first storage capacitor CST1 and the second storage capacitor CST2 may be difficult to be connected by the third gate electrode GE3.

Referring to FIG. 14, the first electrode ELT1 and the second electrode ELT2 may generally extend in the second direction DR2 and may be alternately and repeatedly arranged along the first direction DR1 with the lane EA interposed therebetween. The first electrode ELT1 may be positioned between two lanes EA adjacent to each other in the first direction DR1 in the first area A1. The second electrode ELT2 may be positioned between the first electrode ELT1 of the first sub-pixel SPXL1 and the first electrode ELT1 of the second sub-pixel SPXL2.

The first electrode ELT1 of the first sub-pixel SPXL1 and the first electrode ELT1 of the second sub-pixel SPXL2 may be connected to a first connection line CELT1 extending in the first direction DR1, and the first connection line CELT1 may be connected to the eleventh connection pattern CP11 (and the first vertical power line PL1_V) through the first contact hole CNT1. The first connection line CELT1 may be integrally formed with the first electrode ELT1. That is, the first electrode ELT1 may be electrically connected to the first power line PL1 through the first connection line CELT1 and the first contact hole CNT1. Because the first vertical power line PL1_V is disposed every 4 sub-pixels in the first direction DR1, the first contact hole CNT1 for the first electrode ELT1 may also be disposed every 4 sub-pixels. In addition, the first contact hole CNT1 for the first electrode ELT1 may be positioned as far away from the first area A1 as possible, and thus an influence of the first contact hole CNT1 on the first area A1 may be reduced.

The second electrode ELT2 of the first sub-pixel SPXL1 and the second electrode ELT2 of the second sub-pixel SPXL2 may be connected to a second connection line CELT2 extending in the first direction DR1, and the second connection line CELT2 may be connected to the twenty-first connection pattern CP21 (and the second vertical power line PL2_V) through the first contact hole CNT1. The second connection line CELT2 may be integrally formed with the second electrode ELT2. That is, the second electrode ELT2 may be electrically connected to the second power line PL2 through the second connection line CELT2 and the first contact hole CNT1. Because the second vertical power line PL2_V is disposed every four sub-pixels in the first direction DR1, the first contact hole CNT1 for the second electrode ELT2 may also be disposed every four sub-pixels.

Referring to FIG. 15, the first bank BNK1 may be disposed on the first electrode ELT1 and the second electrode ELT2, and may include an opening corresponding to the first area A1. The opening of the first bank BNK1 may be formed larger than the first area A1. For example, in the opening, upper and lower edges of the first bank BNK1 may coincide with an edge of the first area A1, and a length of the second direction DR2 of the opening may be equal to a length of the second direction DR2 of the first area A1. A width of the first direction DR1 of the opening may be greater than a width of the first direction DR1 of the first area A1. However, the first bank BNK1 (or the opening) is not limited thereto. The width of the first direction DR1 of the first bank BNK1 may be changed according to an amount of a liquid mixture (that is, a mixed liquid or an ink including the light emitting elements) to be injected into the opening of the first bank BNK1.

The first bank BNK1 may not overlap the first connection line CELT1 and the second connection line CELT2. According to one or more embodiments, the first connection line CELT1 and the second connection line CELT2 exposed by the first bank BNK1 may be at least partially removed after the light emitting elements are aligned between the first electrode ELT1 and the second electrode ELT2 (or at the lane EA).

Referring to FIG. 16, a first light emitting element LD1 may be disposed on a right lower lane EA (or a first lane), a second light emitting element LD2 may be disposed on a right upper lane EA (or a second lane), a third light emitting element LD3 may be disposed on a left upper lane EA (or a third lane), and a fourth light emitting element LD 4 may be disposed on a left lower lane EA (or a fourth lane). The first connection electrode CNE1 may overlap a first end of the first light emitting element LD1 and the first electrode ELT1, and may be connected to the first end of the first light emitting element LD1. In addition, the first connection electrode CNE1 may overlap the thirteenth capacitor electrode CE13, and may be connected to the thirteenth capacitor electrode CE13 (or a first storage capacitor CST1) through the second contact hole CNT2. The first connection electrode CNE1 may be electrically separated from the first electrode ELT1.

The second connection electrode CNE2 may be positioned to overlap a second end of the first light emitting element LD1 and the second electrode ELT2. In addition, the second connection electrode CNE2 may be positioned to overlap a first end of the second light emitting element LD2 and the first electrode ELT1. To this end, a portion of the second connection electrode CNE2 may have a curved shape. The second connection electrode CNE2 may connect a second end of the first light emitting element LD1 and the first end of the second light emitting element LD2.

A third connection electrode CNE3 may be positioned to overlap a second end of the second light emitting element LD2 and the second electrode ELT2. In addition, the third connection electrode CNE3 may be positioned to overlap a first end of the third light emitting element LD3 and the first electrode ELT1. The third connection electrode CNE3 may have a shape bypassing the second connection electrode CNE2. The third connection electrode CNE3 may connect the second end of the second light emitting element LD2 and the first end of the third light emitting element LD3.

A fourth connection electrode CNE4 may be positioned to overlap a second end of the third light emitting element LD3 and the second electrode ELT2. In addition, the fourth connection electrode CNE4 may be positioned to overlap a first end of the fourth light emitting element LD4 and the first electrode ELT1. To this end, a portion of the fourth connection electrode CNE4 may have a curved shape. The fourth connection electrode CNE4 may connect the second end of the third light emitting element LD3 and the first end of the fourth light emitting element LD4.

A fifth connection electrode CNE5 may be positioned to overlap a second end of the fourth light emitting element LD4 and the second electrode ELT2. The fifth connection electrode CNE5 may be connected to the second end of the fourth light emitting element LD4. The fifth connection electrode CNE5 may be connected to the second power line PL2 through the third contact hole CNT3 (refer to FIG. 7). The fifth connection electrodes CNE5 of the first and second sub-pixels SPXL1 and SPXL2 (and all sub-pixels) may be connected to each other. For example, the fifth connection electrode CNE5 may extend in the first direction DR1 and the second direction DR2 in the non-emission area (that is, an area excluding the opening of the first bank BNK1), and may entirely arranged in a mesh shape. However, an arrangement of the fifth connection electrode CNE5 is not limited thereto.

The light emitting elements LD1 to LD4 may be connected in series through the connection electrodes CNE1 to CNE5. That is, the first sub-pixel SPXL1 may include four series stages.

Connection electrodes of the second sub-pixel SPXL2 may be arranged symmetrically to the connection electrodes CNE1 to CNE5 of the first sub-pixel SPXL1 based on the sensing line SENL.

In one or more embodiments, a portion of the connection electrodes CNE1 to CNE5 may include a closed loop. For example, the second connection electrode CNE2 may include a closed loop on the second electrode ELT2. Even though a disconnection (that is, an open circuit) occurs in a portion of the second connection electrode CNE2 adjacent to the second end of the first light emitting element LD1, a current may flow through a bypass path formed by the closed loop. For example, the third connection electrode CNE3 may include a closed loop on the second electrode ELT2. Similarly, each of the fourth connection electrode CNE4 and the fifth connection electrode CNE5 may include a closed loop on the second electrode ELT2.

As described above, sub-pixels (for example, the first sub-pixel SPXL1 and the second sub-pixel SPXL2) adjacent to each other with the sensing line SENL interposed therebetween may share the sensing line SENL, and may have a mutually symmetrical structure with respect to the sensing line SENL.

In addition, the storage capacitor CST may include the first storage capacitor CST1 and the second storage capacitor CST2 that are spaced in the second direction DR2 with the first horizontal power line PL1_H interposed therebetween in a plan view. Accordingly, while providing the first area A1, the capacity of the storage capacitor CST may be sufficiently secured within a limited space in the plan view.

FIG. 17 is a layout diagram illustrating another embodiment of the first and second sub-pixels included in the display device of FIG. 11.

Referring to FIGS. 12 and 17, the first sub-pixel SPXL1_1 and the second sub-pixel SPXL2_1 of FIG. 17 may be substantially equal or similar to the first sub-pixel SPXL1 and the second sub-pixel SPXL2 of FIG. 12, respectively, except for the lane EA and the second storage capacitor CST2. Therefore, a repetitive description is omitted.

The first sub-pixel SPXL1_1 may not include the second storage capacitor CST2 of FIG. 12. For example, when a sufficient capacitance is secured only by the first storage capacitor CST1 of the first sub-pixel SPXL1_1 or when the first storage capacitor CST1 of the first sub-pixel SPXL1_1 is formed larger than the first storage capacitor CST1 of the first sub-pixel SPXL1 of FIG. 12, the second storage capacitor CST2 of FIG. 12 may be unnecessary.

In this case, all configurations of the pixel circuit of the first sub-pixel SPXL1_1, that is, the transistors M1 to M3 and the first storage capacitor CST1 may be disposed in an area different from the first area A1 (or the lane EA) based on the first horizontal power line PL1_H. For example, the lane EA of the first sub-pixel SPXL1_1 may be spaced from all configurations of the pixel circuit of the first sub-pixel SPXL1_1 in the second direction DR2 with the first horizontal power line PL1_H interposed therebetween.

The first area A1 of FIG. 17 may be secured more sufficiently than the first area A1 of FIG. 12. For example, a width of the first direction DR1 of the first area A1 of FIG. 17 may be greater than a width of the first direction DR1 of the first area A1 of FIG. 12.

In this case, the first sub-pixel SPXL1_1 may further include an additional lane EA instead of the second storage capacitor CST2 (refer to FIG. 12). The first sub-pixel SPXL1_1 may further include light emitting elements disposed in the additional lane EA. As the number of light emitting elements increases, a luminance of the first sub-pixel SPXL1_1 (and a display device including the same) may increase.

According to one or more embodiments, when the first storage capacitor CST1 of the first sub-pixel SPXL1_1 is formed relatively large, a length of the second direction DR2 of the first area A1 of FIG. 17 may be less than a length of the second direction DR2 of the first area A1 of FIG. 12.

In this case, considering the number of light emitting elements to be disposed in one lane EA, for example, considering that the length of the second direction DR2 of the first area A1 is reduced, the lane EA may be formed relatively long. For example, the first sub-pixel SPXL1_1 may include three lanes EA (or three series stages corresponding thereto). However, embodiments of the present disclosure are not limited thereto. For example, when the length of the second direction DR2 of the first area A1 is sufficiently long, two lanes EA may be disposed in one row similarly to the lane EA of FIG. 12, and the first sub-pixel SPXL1_1 may include a total of six lanes EA (or six series stages corresponding thereto).

As described above, the second storage capacitor CST2 (refer to FIG. 12) may be omitted. In addition, a disposition of the lane EA may be freely changed in consideration of a size of the first area A1.

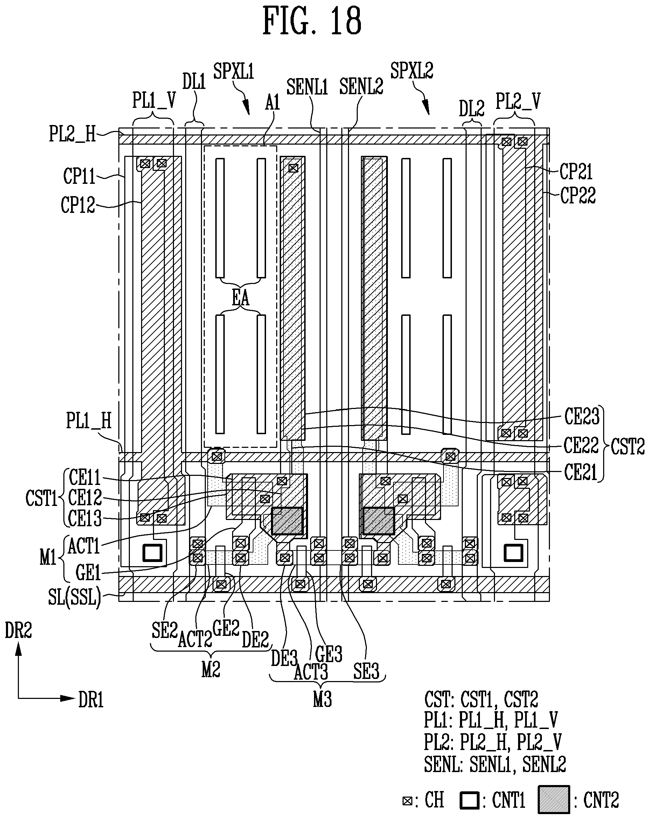

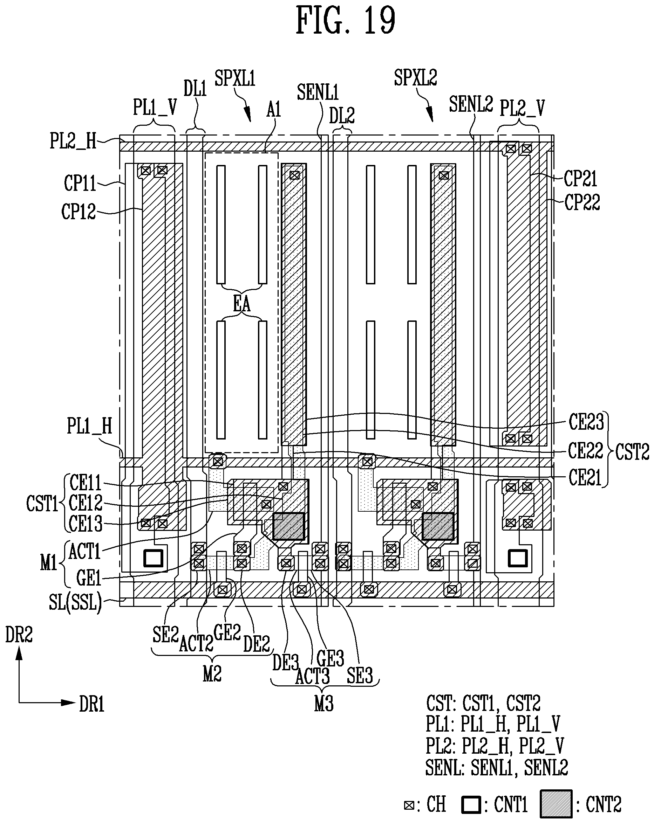

FIG. 18 is a layout diagram illustrating one or more embodiments of the first and second sub-pixels included in the display device of FIG. 3. FIG. 19 is a layout diagram illustrating an embodiment of the first and second sub-pixels included in the display device of FIG. 3.

Referring to FIGS. 12 and 18, the embodiment of FIG. 18 may be substantially equal or similar to the embodiment of FIG. 12 except for the sensing line SENL. Therefore, a repetitive description is omitted.

The sensing line SENL may be provided for each of the first sub-pixel SPXL1 and the second sub-pixel SPXL2 (or the sub-pixels SPXL1 to SPXL3 of FIG. 3).

Each of a first sensing line SENL1 and a second sensing line SENL2 may extend in the second direction DR2, and may be positioned between the first sub-pixel SPXL1 and the second sub-pixel SPXL2.

The first sensing line SENL1 may be connected to the third semiconductor pattern ACT3 (that is, the third transistor M3) of the first sub-pixel SPXL1. Similarly, the second sensing line SENL2 may be connected to the third semiconductor pattern ACT3 (that is, the third transistor M3) of the second sub-pixel SPXL2.

In this case, a sensing signal of the first sub-pixel SPXL1 (or a characteristic of the first sub-pixel SPXL1 corresponding thereto, for example, the threshold voltage of the like of the first transistor M1) may be obtained or detected independently through the first sensing line SENL1. Similarly, a sensing signal of the second sub-pixel SPXL2 (or a characteristic of the second sub-pixel SPXL2 corresponding thereto) may be obtained or detected independently through the second sensing line SENL2.

For reference, according to the embodiment of FIG. 12, when the first sub-pixel SPXL1 and the second sub-pixel SPXL2 share one sensing line SENL, the sensing signal of the first sub-pixel SPXL1 and the sensing signal of the second sub-pixel SPXL2 may be obtained through one sensing line SENL. In order to obtain only the sensing signal of the first sub-pixel SPXL1 or the second sub-pixel SPXL2, the first sub-pixel SPXL1 or the second sub-pixel SPXL2 is required to be driven in time division, and in this case, a sensing time for obtaining the sensing signals of the first sub-pixel SPXL1 and the second sub-pixel SPXL2 (and all sub-pixels) may be increased. In the embodiment of FIG. 18, the sensing signals of the first sub-pixel SPXL1 and the second sub-pixel SPXL2 may be concurrently (e.g., simultaneously) and independently obtained through the first and second sensing lines SENL1 and SENL2, the sensing time may be shortened. For example, when sufficiently securing the first area A1 is difficult due to the second storage capacitor CST2 or the like, one sensing line SENL may be provided to the first sub-pixel SPXL1 and the second sub-pixel SPXL2 according to the embodiment of FIG. 12. In contrast, when the second storage capacitor CST2 is omitted and thus the first area A1 is sufficiently secured, the first and second sensing lines SENL1 and SENL2 may be provided to the first sub-pixel SPXL1 and the second sub-pixel SPXL2, respectively.

Referring to FIGS. 18 and 19, the second sub-pixel SPXL2 according to the embodiment of FIG. 18 may have a structure symmetrical to the first sub-pixel SPXL1, and the second sub-pixel SPXL2 according to the embodiment of FIG. 19 may have the same structure as the first sub-pixel SPXL1. That is, in the embodiment of FIG. 19, the transistors, the capacitor, and the like of the second sub-pixel SPXL2 may be arranged identically to the transistors, the capacitor, and the like of the first sub-pixel SPXL1.

As described above, the sensing line SENL may be provided for each sub-pixel. In addition, the sub-pixels may have the same structure instead of a symmetrical structure.

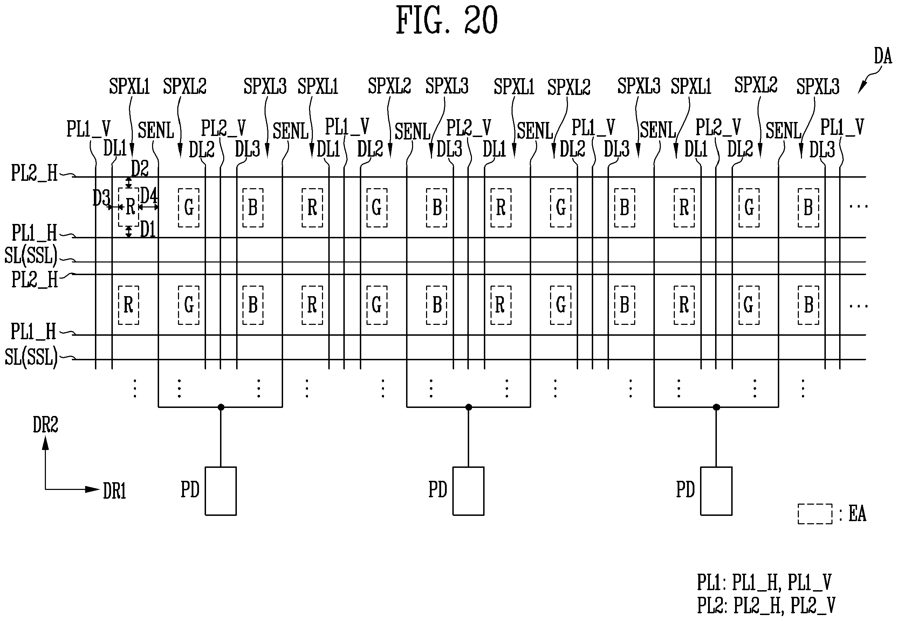

FIGS. 20, 21, and 22 are plan views illustrating an embodiment of the display device of FIG. 3.

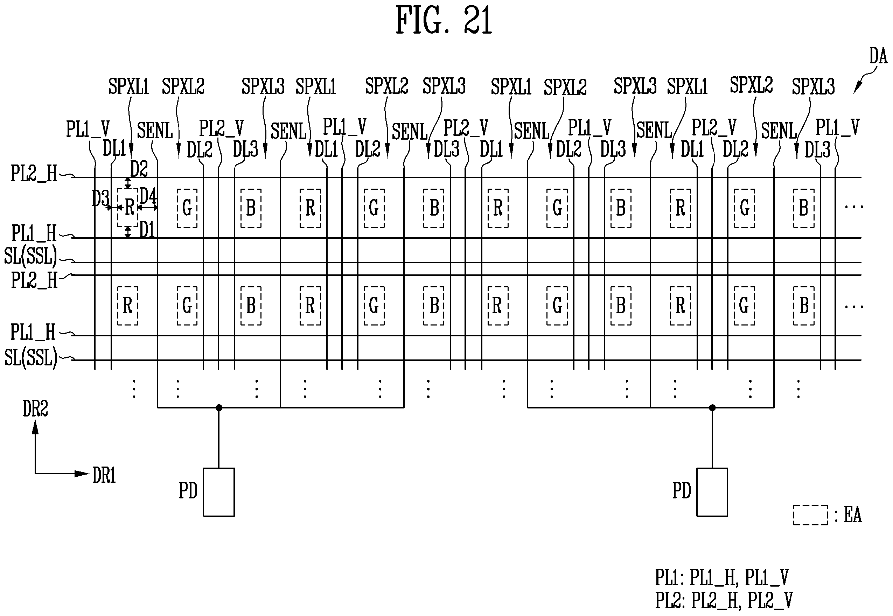

First, referring to FIGS. 11, 20, and 21, the display devices of FIGS. 20 and 21 may be equal or similar to the display device of FIG. 11 except for a connection configuration of the pad PD and the sensing line SENL. Therefore, a repetitive description is omitted.

The pad PD may be disposed in the non-display area NDA (refer to FIG. 3) and may be connected to a driver (for example, a driving integrated circuit), or the like.

In one or more embodiments, at least two sensing lines SENL may be connected to one pad PD. That is, similar to an embodiment in which the first and second sub-pixels SPXL1 and SPXL2 share one sensing line SENL as described with reference to FIG. 12, a greater number of sub-pixels SPXL1 to SPXL3 may substantially share one sensing line SENL.

For example, as shown in FIG. 20, two sensing lines SENL may be connected to one pad PD. In this case, four sub-pixels included in one row may be connected to one pad PD.

As another example, as shown in FIG. 21, three sensing lines SENL may be connected to one pad PD. In this case, six sub-pixels included in one row may be connected to one pad PD.

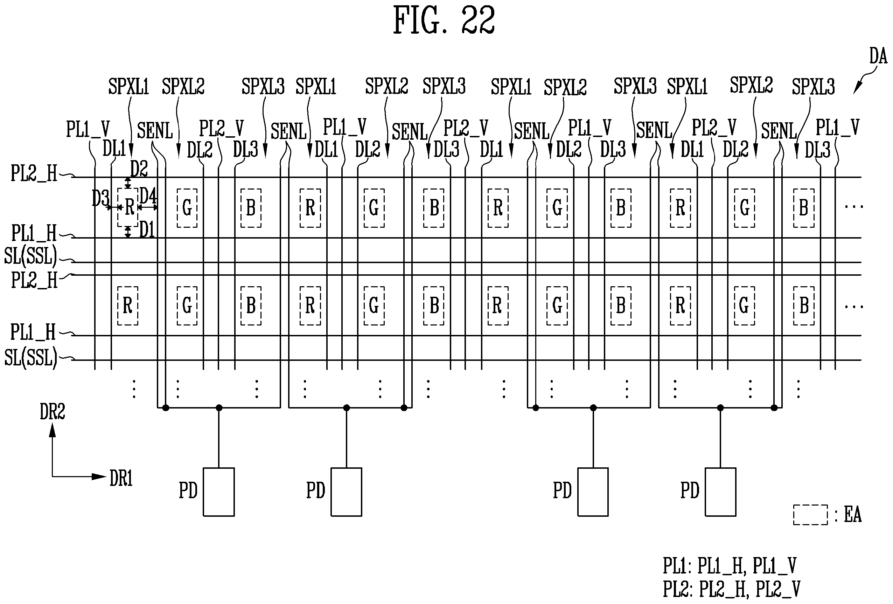

Referring to FIGS. 18, and 22, two sensing lines SENL may be disposed between two adjacent sub-pixels from among the sub-pixels SPXL1 to SPXL3. Even in this case, at least two sensing lines SENL may be connected to one pad PD.

For example, a total of three sensing lines SENL for the first sub-pixel SPXL1, the second sub-pixel SPXL2, and the third sub-pixel SPXL3 may be connected to one pad PD. That is, three sub-pixels configuring one pixel may be connected to one pad PD.

As described above, at least two sensing lines SENL may be connected to one pad PD, and at least three sub-pixels may be connected to one pad PD. That is, at least three sub-pixels may substantially share one sensing line SENL.

As discussed, embodiments can provide a display device comprising: a pixel circuit layer on a base layer and comprising conductive patterns forming at least one of a transistor, a capacitor, or a signal line; a first electrode and a second electrode on the pixel circuit layer and spaced from each other; a bank on the first electrode and the second electrode and including an opening; and light emitting elements between the first electrode and the second electrode in the opening of the bank, wherein in the opening of the bank, a space between the first electrode and the second electrode that are spaced from each other by a distance corresponding to a length of the light emitting elements is defined as a lane in which the light emitting elements are located, and wherein in a plan view, the lane does not overlap the conductive patterns of the pixel circuit layer and is spaced from the conductive patterns by a distance equal to or greater than half of the length of the light emitting elements.

The lane may not overlap any conductive pattern of the pixel circuit layer. Hence, only insulating layers of the pixel circuit layer may overlap the lane. The lane may overlap an electrode-free area of the pixel circuit layer.

The first electrode may be a first alignment electrode and the second electrode may be a second alignment electrode, or a second reflective electrode).

The light emitting elements may emit light based on a first electrical signal (for example, an anode signal) provided from a first connection electrode and a second electrical signal (for example, a cathode signal) provided from a second connection electrode. The first connection electrode and the second connection electrode may be on the first electrode and the second electrode.

The first connection electrode may be on the first electrode, and separated by an insulating layer. The first connection electrode may be connected to a transistor in the pixel circuit layer via a contact hole in the insulating layer.

The second connection electrode may be on the second electrode, and separated by an insulating layer. The second connection electrode may be connected to a power line in the pixel circuit layer via a contact hole in the insulating layer.

The display device may comprise sub-pixels, each of the sub-pixels comprising a said lane.

Sub-pixels may be arranged along a first direction, and a signal line may extend in a second direction between a pair of adjacent sub-pixels from among the sub-pixels. In some embodiments, a pair of adjacent sub-pixels may be commonly connected to the signal line and may be symmetric with each other with respect to the signal line. The signal line may be, for example, an initialization power line.

Embodiments can also provide a display device comprising: sub-pixels arranged along a first direction; and a signal line extending in a second direction between a pair of adjacent sub-pixels from among the sub-pixels, wherein each of the sub-pixels comprises: a pixel circuit comprising a transistor and a capacitor; a first electrode and a second electrode electrically connected to the pixel circuit and spaced from each other in a plan view; and light emitting elements in a lane defined as being between the first electrode and the second electrode, a conductive pattern that is not in the lane, and wherein the pair of adjacent sub-pixels are commonly connected to the signal line and are symmetric with each other with respect to the signal line.

Although the present disclosure has been described with reference to the embodiments above, those skilled in the art or those having a common knowledge in the art will understand that the present disclosure may be variously modified and changed without departing from the technical scope of the present disclosure described in the claims and their equivalents which will be described later.

Therefore, the technical scope of the present disclosure should not be limited to the contents described in the detailed description of the specification, but should be defined by the claims and their equivalents.

## Claims

1. A display device comprising:
a pixel circuit layer on a base layer and comprising conductive patterns forming at least one of a transistor, a capacitor, or a signal line;
a first electrode and a second electrode on the pixel circuit layer and spaced from each other;
a bank on the first electrode and the second electrode and including an opening; and
light emitting elements between the first electrode and the second electrode in the opening of the bank,
wherein in the opening of the bank, a space between the first electrode and the second electrode that are spaced from each other by a distance corresponding to a length of the light emitting elements is defined as a lane in which the light emitting elements are located, and
wherein in a plan view, the lane does not overlap the conductive patterns of the pixel circuit layer and is spaced from the conductive patterns by a distance equal to or greater than half of the length of the light emitting elements.

2. The display device according to claim 1, wherein:
the length of the light emitting elements is about 10 µm or less, and
in a plan view, the lane is spaced from the conductive patterns by a distance of about 6 µm or more.

3. The display device according to claim 1 or 2, wherein:
the pixel circuit layer further comprises insulating layers,
some of the conductive patterns are interconnected through a contact hole passing through a portion of the insulating layers, and
in a plan view, the lane is spaced from all contact holes by a distance equal to or greater than half of the length of the light emitting elements.

4. The display device according to any one of claims 1 to 3, further comprising:
sub-pixels each including the lane,
wherein the conductive patterns comprise a first line extending in a second direction, and
wherein, from among the sub-pixels, a first sub-pixel and a second sub-pixel adjacent in a first direction with the first line interposed therebetween are symmetric with each other with respect to the first line in a plan view,
wherein the first sub-pixel and the second sub-pixel share the first line, and
wherein the first line is repeatedly arranged along the first direction with a distance corresponding to two of the sub-pixels.

5. The display device according to claim 4, wherein the conductive patterns comprise a first power line and a second power line extending in the second direction,
wherein the light emitting elements are electrically connected between the first power line and the second power line,
wherein the first power line and the second power line are spaced from each other with a gap corresponding to two of the sub-pixels,
wherein each of the first power line and the second power line is repeatedly arranged along the first direction with a distance corresponding to four of the sub-pixels,
wherein each of the first power line and the second power line comprises three conductive layers that are spaced with insulating layers interposed therebetween,
wherein the conductive patterns further comprise a first auxiliary power line and a second auxiliary power line extending in the first direction,
wherein the first auxiliary power line is electrically connected to the first power line, and
wherein the second auxiliary power line is electrically connected to the second power line.

6. The display device according to claim 5, wherein the first electrode and the second electrode extend in the second direction and are alternately and repeatedly arranged along the first direction, and
wherein the first electrode is electrically connected to the first power line through a first connection line extending in the first direction and a first contact hole.

7. The display device according to any one of claims 1 to 4, wherein the conductive patterns comprises:
a first auxiliary power line extending in a first direction; and
a first capacitor and a second capacitor spaced in a second direction with the first auxiliary power line interposed therebetween in a plan view,
wherein the first capacitor and the second capacitor are electrically connected in parallel.

8. The display device according to any one of claims 1 to 7, further comprising:
connection electrodes on the light emitting elements,
wherein the lane comprises a first lane, a second lane, a third lane, and a fourth lane that are spaced from each other in the opening of the bank,
wherein the light emitting elements comprise first light emitting elements in the first lane, second light emitting elements in the second lane, third light emitting elements in the third lane, and fourth light emitting elements in the fourth lane,
wherein the first to fourth light emitting elements are electrically connected in series through the connection electrodes, and
wherein a portion of the connection electrodes comprises a closed loop.

9. The display device according to any one of claims 1 to 8, further comprising:
color conversion particles on the light emitting elements and converting a wavelength of light of the light emitting elements; and
a color filter on the color conversion particles.

10. The display device according to any one of claims 1 to 4, wherein:
the conductive patterns comprise a first auxiliary power line extending in a first direction, and
in a plan view, the lane of a sub-pixel is in an area that is different from the transistor and the capacitor of the pixel circuit layer of the sub-pixel based on the first auxiliary power line.

11. The display device according to any one of claims 1 to 3, further comprising:
a first sub-pixel and a second sub-pixel, each of the first sub-pixel and the second sub-pixel comprising the lane,
wherein the conductive patterns comprise first lines extending in a second direction, and
wherein the first sub-pixel and the second sub-pixel that are adjacent to two of the first lines interposed therebetween are symmetric with each other with respect to the two of the first lines in a plan view.

12. The display device according to claim 11, wherein three of the first lines are connected to one pad.

13. The display device according to any one of claims 1 to 3, further comprising:
sub-pixels, each of the sub-pixels comprising the lane,
wherein the conductive patterns comprise first lines extending in a second direction,
wherein from among the sub-pixels, a first sub-pixel and a second sub-pixel adjacent with one of the first lines interposed therebetween are symmetric with each other with respect to the first line in a plan view, and
wherein at least two of the first lines are connected to one pad.

14. A display device comprising:
sub-pixels arranged along a first direction; and
a signal line extending in a second direction between a pair of adjacent sub-pixels from among the sub-pixels,
wherein each of the sub-pixels comprises:
a pixel circuit comprising a transistor and a capacitor;
a first electrode and a second electrode electrically connected to the pixel circuit and spaced from each other in a plan view; and
light emitting elements in a lane defined as being between the first electrode and the second electrode,
a conductive pattern that is not in the lane, and
wherein the pair of adjacent sub-pixels are commonly connected to the signal line and are symmetric with each other with respect to the signal line.

15. The display device according to claim 14, wherein, in a plan view, the lane is located in an area that is different from the transistor based on a first line extending in the first direction,
wherein the pixel circuit comprises a first capacitor and a second capacitor that are spaced in the second direction with the first line interposed therebetween, and
wherein the first capacitor and the second capacitor are electrically connected in parallel.
